# EUROPEAN PATENT SPECIFICATION

(11) **EP 1 710 292 B1**
(45) Date of publication and mention of the grant of the patent: **02.03.2011**
(21) Application number: 06251441.9
(22) Date of filing: 17.03.2006
(51) Int. Cl.: C09K 11/64

(54) **Powdered fluorescent material and method for manufacturing the same, light-emitting device, and illumination apparatus**
Pulverförmiges fluoreszentes Material und Verfahren zu seiner Herstellung, lichtemittierende Vorrichtung und Beleuchtungsvorrichtung
Matériau fluorescent en poudre, méthode de fabrication, dispositif électroluminescent et appareil d'éclairage

(30) Priority: 18.03.2005 JP 2005079662
(43) Date of publication of application: 11.10.2006
(73) Proprietor: FUJIKURA LTD., Kohtoh-ku, Tokyo (JP); Independent Administrative Institution National Institute for Materials Science, Tsukuba-shi, Ibaraki-ken (JP)
(72) Inventor: Sakuma, Ken c/o Fujikura Ltd., Sakura-shi Chiba-ken (JP); Kimura, Naoki c/o Fujikura Ltd., Sakura-shi Chiba-ken (JP); Omichi, Koji c/o Fujikura Ltd., Sakura-shi Chiba-ken (JP); Hirosaki, Naoto c/o Independent Administrative Institution, Tsukuba-shi Ibaraki-ken (JP)
(74) Representative: Carter, Stephen John

(56) References cited:
- EP-A1- 1 503 428
- WO-A-03/082564
- US-A- 5 160 663
- US-A1- 2004 145 307
- US-A1- 2005 194 604
- DATABASE WPI Week 200569 Derwent Publications Ltd., London, GB; AN 2005-668885 XP002405880 -& JP 2005 255885 A (DOKURITSU GYOSEI HOJIN BUSSHITSU ZAIRYO) 22 September 2005 (2005-09-22) & JP 2005 255885 A (NAT INST FOR MATERIALS SCIENCE) 22 September 2005 (2005-09-22)

## Description

### BACKGROUND OF THE INVENTION

### Field of the Invention

The present invention relates generally to a light-emitting device for illumination, and more particularly to a method for manufacturing a powdered fluorescent material for improving the luminous efficacy of powdered fluorescent material provided in said device, powdered fluorescent material with improved luminous efficacy, a light-emitting device with improved luminous efficacy, and an illumination apparatus provided with said light-emitting device.

Priority is claimed on Japanese Patent Application No. 2005-079662, filed March 18, 2005.

### Description of Related Art

Conventionally, a light-emitting diode (hereinafter, referred to as "LED") element emitting light in the short-wavelength range such as blue light, and a white LED lamp, which uses fluorescent element that emits fluorescent light such as yellow light on the long wavelength side and which is excited after absorbing all or a part of the light emitted by the LED, are generally well known. Conventional techniques related to white LED lamps and fluorescent (phosphor) materials used therefor have been disclosed in various documents.

One such example is a white LED lamp including a compound semiconductor blue LED element and a cerium-activated yttrium-aluminum-garnet (hereafter referred to as YAG) fluorescent material that absorbs blue light and emits yellow, complementary color to blue, fluorescence, which is described in Japanese Patent No. 2927279 and the like.

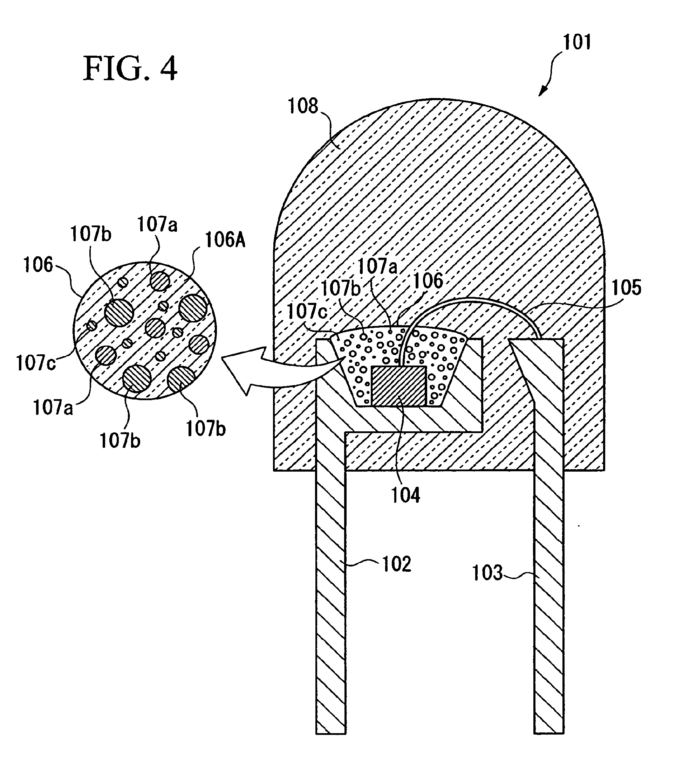

The configuration of the conventional LED lamp is described with reference to FIG. 4.

A conventional white LED lamp 101 comprises two lead wires 102 and 103. A recess is formed in the lead wire 102, and a blue LED element 104 is placed in this recess. The lower electrode provided on the underside of this blue LED element 104 is coupled to the bottom surface of the recess of the lead wire 102. The upper electrode provided on the upper surface of the blue LED element 104 is electrically connected to the other lead wire 103 through the bonding wire 105. The blue LED element 104 is covered by a resin layer 106 dispersed with a fluorescent material, which includes powdered fluorescent materials 107a, 107b, and 107c (hereinafter, collectively referred to as "fluorescent material 107") having different particle sizes in a transparent resin 106A, is filled in the recess. The tips of the lead wires 102 and 103 including the recess, the blue LED element 104, and the fluorescent material dispersed resin layer 106 are sealed by a transparent molding resin 108, while the lower ends of the lead wires 102 and 103 protrude from the molding resin 108 and are exposed. The transparent molding resin 108 has an approximately cylindrical shape on the whole, and its front end is molded to a curved surface in the form of a lens. Such a white LED lamp 101 is called "bullet-shaped" LED because of its shape. This powdered fluorescent material 107 is dispersed in the fluorescent material-dispersed resin layer 106 in the conventional white LED lamp 101. In this case, the particle size of powdered fluorescent material 107 should be optimized.

If the particle size of powdered fluorescent material is large, generally, its luminous efficiency is excellent. That is, layers with lower luminous efficiency (low efficiency layer) exist on the surface, the luminous efficiency of which is lower than in the inner part of the fluorescent material, and when the particle size is small, the frequency of passage of electron beams through the low efficiency layer increases at high voltages. As a result, the luminous efficiency cannot be ensured (for instance, refer to "Phosphor Handbook," Japanese Edition, edited by Phosphor Research Society, 1987, pp. 172-173).

On the other hand, particles with large size have poor coating properties.

Accordingly, after considering the luminous efficiency and the coating properties as mentioned above, particles with a size of about 3 µm are used for aluminate based fluorescent material in fluorescent lamp and Y₂O₃; Eu³⁺, while particles with a size of about 8 µm are used in calcium halophosphate. Particles with sizes of about 5 to 7 µm are used in fluorescent materials for cathode ray tubes. Studies on the particle size are being performed even for fluorescent materials for white LED lamps. A particle size 20 µm or less and a d₅₀ value less than 5 µm are recommended for luminescent pigments (fluorescent materials). Furthermore, a d₅₀ value of 1 µm to 2 µm is considered to be the most desirable (for instance, refer to Japanese Patent No. 3364229).

The d₅₀ value mentioned above is the average size of particles that account for 50% of the number or the mass of all particles.

White LED lamp is a type of mercury-free lamp considering the environment, and has a long service life; therefore, bulb replacement is not necessary. As a result, illumination apparatus can be made maintenance free. In view of these advantages, the white LED lamp is anticipated to form the core of light sources of the next-generation illumination apparatus.

Presently, a large number of white LED illumination apparatus with high luminous efficacy and adequate emission intensity are commercially available, but further enhanced emission intensity and improved luminous efficacy are urgently required with the aim of expanding applications and conserving energy further.

For this reason, not only are studies for improving the characteristics of blue LED element necessary, but also studies for enhancing the light extraction efficiency by improving the wavelength conversion efficiency of the fluorescent material and by improving the mounting design are indispensable.

In the past, fluorescent material was dispersed in transparent resin, which was used as the coating to cover the blue LED element. That is, from the light emitted from the blue LED element, those components not absorbed in the fluorescent material were extracted outside the LED lamp after passing through the resin layer in which fluorescent material was dispersed. Moreover, the yellow light converted from the blue light by the fluorescent material particles was also extracted outside the LED lamp after passing through the fluorescent material-dispersed resin layer which was positioned more on the outside than the fluorescent materials.

According to Japanese Unexamined Patent Application, First Publication No. 2002-299692 and according to K. YAMADA, Y. IMAI and K. ISHII, "Optical Simulation of Light Source Devices Composed of Blue LEDs and YAG Fluorescent material," J. Light & Vis. Env., Vol.27, No.2 (2003), pp. 70-74, when the percentage of the fluorescent material in the fluorescent material-dispersed resin increases above a specific value, its transmittance becomes inadequate. If the transmittance of the fluorescent material-dispersed resin layer in the LED lamp is inadequate, the light extraction efficiency deteriorates.

To resolve the problem mentioned above, unexamined patent application publication No. 2002-299692 and K. YAMADA, Y. IMAI and K. ISHII, "Optical Simulation of Light Source Devices Composed of Blue LEDs and YAG Fluorescent material," J. Light & Vis. Env., Vo1.27, No.2 (2003), pp. 70-74, propose a reflective-type structure. However, the reflective-type structure is more complex than the conventional structure of white LED lamp, and a large quantity of the fluorescent material becomes necessary, which is also an issue.

US 2004/145307 discloses a red light emitting phosphor with a particle size of 53 microns, which is manufactured by sintering the raw material, followed by washing with an aqueous solution that can be agitated. In one example the solution is a hydrochloric acid aqueous solution and immersion is for 30 minutes.

US 3,255,373 discloses a halophosphate phosphor material for use in fluorescent lamps, said phosphor material being in the form of a plurality of finely-divided particles, and substantially all of said phosphor particles having an average diameter of at least about 4 microns. During manufacture, the material is reduced in a hammer mill and after reduction introduced to a liquid vehicle, such as water, and stirred to form a slurry. The phosphor disperses in the slurry and is allowed to settle for a period of approximately 3 hours.

### SUMMARY OF THE INVENTION

In the light of the circumstances mentioned above, the present invention has as its preferred objects to provide powdered fluorescent material, method for manufacturing the same, and a light emitting device capable of enhancing the visible light transmittance of the fluorescent material-dispersed resin for improving the luminous efficacy of white LED lamp with the same simple and inexpensive structure of the conventional white LED lamp.

A first aspect of the present invention provides powdered fluorescent material excited by visible light, which emits visible light, and which includes particles of powdered fluorescent material with particle sizes of 20 µm or less at a content of below 2% by mass.

The powdered fluorescent material of the present invention may have a median particle size not less than 30 µm and not more than 80 µm.

A particle size at which the cumulative weight of the particles becomes 90% is preferably 100 µm or less.

A particle size at which the cumulative weight of the particles becomes 10% is preferably 30 µm or greater, and a median particle size is preferably not less than 40 µm and not more than 70 µm.

The powdered fluorescent material of the present invention may be excited by blue light and may emit visible light in a range between bluish green light and red light.

The powdered fluorescent material of the present invention may be an oxynitride fluorescent material or a nitride fluorescent material.

The powdered fluorescent material of the present invention may be a europium-activated SiAION.

Additionally, the above-mentioned SiAlON may be a calcium α-SiAlON.

A second aspect of the present invention provides a method for manufacturing the powdered fluorescent material of the first aspect, comprising the steps of: sintering a raw material powder of the fluorescent material; dispersing the powder in a liquid after said sintering, and stirring or subjecting to vibration; and removing said liquid wherein the fine powder is dispersed after said stirring or after being subjected to said vibration while said powder is being suspended and has not settled down to obtain only settled down coarse particles.

In the method for manufacturing said powdered fluorescent material, after stirring is complete or after vibration has been applied, the liquid containing the fine particles suspended therein may be removed within 2 minutes.

In the method for manufacturing a powdered fluorescent material of the present invention, said powdered fluorescent material may be a nitride fluorescent material or an oxynitride fluorescent material activated by rare-earth elements.

In the method for manufacturing a powdered fluorescent material of the present invention, at least one of said rare-earth elements may be europium.

In the method for manufacturing a powdered fluorescent material of the present invention, said fluorescent material may be a calcium α-SiAlON.

The sintered powder may be chemically processed in an acid solution after sintering. Said acid solution may be an acid mixture solution including hydrofluoric acid, sulfuric acid, and water.

The method may also comprise a granulation step wherein a wet-mixed raw material powder is placed in a sieve, subjected to vibration or shock to obtain an aggregate of said raw material powder. The sintering step may take place after said granulation step. Said sieve may have a nominal mesh size of 40 µm to 200 µm.

Additionally, a third aspect of the present invention provides a light-emitting device comprising a semiconductor light-emitting element emitting visible light, and said powdered fluorescent material according to the first aspect of the present invention disposed so as to emit fluorescent light activated by visible light emitted from said semiconductor light-emitting element.

In the light-emitting device of the third aspect of the present invention, said semiconductor light-emitting element may be a blue LED element, and said powdered fluorescent material may be a europium-activated calcium α-SiAlON.

A fluorescent material-dispersed resin layer formed by dispersing said powdered fluorescent material in a transparent resin to surround said semiconductor light-emitting element may also be disposed.

A fourth aspect of the present invention provides an illumination apparatus having the light-emitting device of the third aspect of the present invention mentioned above as a light source.

By setting the content of particles with particle sizes of 20 µm or less to below 2% by mass in the powdered fluorescent material of the present invention, and by dispersing the particles in a transparent material such as a transparent resin, the Mie scattering can be suppressed; the visible light transmittance of the fluorescent material-dispersed resin can be enhanced when providing it in a light-emitting device such as white LED lamp, and the light extraction efficiency of light-emitting devices, such as white LED lamps, can be improved.

According to the method for manufacturing a powdered fluorescent material of the present invention, when manufacturing the powdered fluorescent material after sintering a raw material powder of the fluorescent material; the fine particles, such as particles with particle sizes of 20 µm or less are preferably dissolved by performing a step in which, after sintering, the powdered is chemically treated in an acid solution. The glassy substance on the surface of the powdered fluorescent material dissolves and the particles dissociate. It becomes difficult for fine particles to adhere to the powdered fluorescent material of the desired particle size and to remain, and by washing the powdered fluorescent material after the chemical treatment, only the fine particles can be easily removed by washing. This enables a powdered fluorescent material with a low content of fine particles to be manufactured at good efficiency.

The light-emitting device of the third aspect of the present invention comprises a semiconductor light-emitting element and a fluorescent material-dispersed resin layer having a powdered fluorescent material having particle sizes of 20 µm or less dispersed therein at the content below 2% by mass and preferably covering the semiconductor light-emitting element, which suppresses the occurrence of Mie scattering in fluorescent material-dispersed resin layer. Since the visible light transmittance of the fluorescent material-dispersed resin layer can be enhanced, a light-emitting device with excellent light extraction efficiency can be provided.

### BRIEF DESCRIPTION OF THE DRAWINGS

FIG. 1 is a cross-sectional view of the bullet-shaped white LED lamp, which is one embodiment of the light-emitting device of the present invention.
FIG. 2 is a cross-sectional view of a chip-shaped white LED lamp, which is another embodiment of the light-emitting device of the present invention.
FIG. 3 is a graph showing the emission spectrum and excitation spectrum of a powdered fluorescent material manufactured in an example of the present invention and a commercially available fluorescent material.
FIG. 4 is a cross-sectional view of an example of a conventional bullet-shaped white LED lamp.
FIG. 5 is a graph showing the results of measurement of particle size distributions of a commercially available YAG based fluorescent material of Experiment 1 sized into Samples S, M, and L.
FIG. 6 is a graph showing particle size distributions of the commercially available YAG based fluorescent material of Experiment 1 sized into Samples S, M, and L as frequency distributions.
FIG. 7 is a graph showing the emission spectra (excitation wavelength 460 nm) of the commercially available YAG based fluorescent material of Experiment 1 sized into Samples S, M, and L.
FIG. 8 is a graph showing the emission spectrum of a white LED lamp provided with Samples S, M, and L of Experiment 1.
FIG. 9 is a graph showing the frequency distribution of luminous efficacy of white LED lamp provided with an α-SiAlON powdered fluorescent material (Sample 2A, 2B, 2C) prepared in Experiment 2.
FIG. 10 is a graph showing the emission spectrum of samples before a chemical treatment of the α-SiAION powdered fluorescent material (Samples FY 10-45 and FY10-63) prepared in Experiment 3.
FIG 11 is a graph showing the emission spectrum of samples after the chemical treatment of the α-SiAION powdered fluorescent material (Samples FY10-45 and FY10-63) prepared in Experiment 3.
FIG. 12 is a graph showing the frequency distributions after the chemical treatment of the α-SiAlON powdered fluorescent material of Sample FY10-45 prepared in Experiment 3.
FIG. 13 is a graph showing the frequency distributions after the chemical treatment of the α-SiAlON powdered fluorescent material of Sample FY10-63 prepared in Experiment 3.
FIG. 14 is a diagram showing the scanning electron microscope image of an α-SiAlON powdered fluorescent material prepared in Experiment 5.
FIG . 15 is a graph showing the emission spectrum of a white LED lamp prepared in Example 2.
FIG. 16 is a graph showing the comparison of the emission spectrum of the white LED lamp manufactured in Example 2 and the emission spectrum of the commercially available product.

### DETAILED DESCRIPTION OF THE INVENTION

Considerations for a powdered fluorescent material and a light-emitting device of the present invention are as below.

### Consideration 1

The phenomenon of light not passing through a transparent film dispersed densely with fine particles is known to be a problem of Anderson localization of light (for instance, see Toshiaki Iwai, Takashi Okamoto, and Toshimitsu Asakura, "New Developments of Laser Light - Scattering Phenomena," OYO BUTURI, Vol. 63, No. 1, pp. 14-22).

When light is incident on a transparent solution (sample) dispersed with particles having the same diameter or smaller diameter than that of the incident light, and if the solution is dilute, the incident light is scattered only once in the particles and then emitted outside the sample. If the concentration of the particles in the sample increases, the incident light will be scattered repeatedly by a large number of particles. That is, the mean free path of light becomes shorter. With the increase in the particle concentration in the sample, the straight-ahead transmitted light reduces because of the forward scatter, the scattered light components account for a major share of the energy of exited light, and its intensity distribution will be distributed uniformly over a wide area of space. At this time, coherent scattering light peak can be observed in the backward multiple scattered light called "Enhanced Backscattering" in the direction opposite to the incident. In recent years, research on this backscattering peak has been carried out extensively. Requirements for occurrence of the Anderson localization of light include high refractive index of scatterer, scattering at high density, and the size about the same as that of the light wavelength.

### Consideration 2

A series of papers by Naganuma et al. can be considered for research related to transmittance of particle-dispersed transparent materials. In such research, the effects of particle size and the volume fraction of particles on the light transmittance of particle-dispersed optical composite materials were studied from the viewpoint that transmittance improves by suppressing scatter, and guidelines for particle forms for improving the optical transmittance have been disclosed.

According to T. NAGANUMA and Y. KAGAWA, "EFFECT OF PARTICLE SIZE ON LIGHT TRANSMITTANCE OF GLASS PARTICLE DISPERSED EPOXY MATRIX OPTICAL COMPOSITES," Acta Mater. Vol. 47, No. 17, pp. 4321-4327 (1999), the transmittance of a composite material improves in the composite material having glass particles dispersed in epoxy resin with the increase in the mean particle size dₚ. The dₚ of the samples used in experiments in the relevant papers are 26 µm, 42 µm, 59 µm, and 85 µm. The standardized transmittance can be represented by the equation Tc(λ)/Tm(λ)=b₁exp[-b₂<Sa>{ΔNc(λ)}]. In the above equation, Tc(λ) is the transmittance of the composite material (composite), Tm(λ) is the transmittance of the epoxy resin (matrix), and b₁ and b₂ are constants. <Sa> is the total surface area of the normalized particles, and is defined as follows: <Sa> = S/vc = Sₚfₚρₚ. Here, S is the total surface area, Vc is the volume of the composite material, Sₚ is the specific surface area of the particles per unit mass (determined from the BET method), fₚ is the volume fraction of the particles, and ρₚ is the density of the particles. ΔNc(λ) is a parameter in which the effects of the difference in the refractive indices of the particles and epoxy resin are introduced. The paper concludes that the transmittance of composite materials can be improved by reducing the total area of the normalized particles, i.e., the area of the interface between particles and the matrix.

The results of studies on the transmittance of composite materials when the volume fraction of particles fₚ was varied from 0.0001 to 0.4 have been reported in Tamaki Naganuma and Yutaka Kagawa, "Effect of total particle surface area on the light transmittance of glass particle-dispersed epoxy matrix optical composites," J. Mater. Res., Vol. 17, No. 12 (2002). The dₚ of the two samples used in the experiment in the paper was 26 µm and 85 µm, and these are results of studies in the geometric optical region. In the range of particle volume fractions of fₚ < 0.01, the transmittance only decreases very slightly when the particle volume fraction increases. However, in the range of fₚ > 0.01, the transmittance decreases abruptly with the increase in the volume fraction ratio of particles. Moreover, the transmittance also reduces significantly due to the reduction in particle size. Said paper has clarified that the effects of a particle volume fraction and a particle size on the transmittance of light can be composition of the powdered fluorescent material interpreted by introducing the relative total surface area <S>, which represents the sum of the surface areas of all particles included in unit volume of composite material. As a result, to increase the transmittance of light in composite materials in the geometric optical region where the particle size is adequately larger than the wavelength of incident light, it is preferable to make <S> as small as possible. That is, the report states the guideline for particle form that it is preferable to select particles having a larger size with a shape close to the spherical shape. Note that the <S> mentioned here is the same as <Sa> mentioned earlier.

Furthermore, "particles as close to the spherical shape as possible should be selected using a particle size in the order of several tens of microns or greater, which are adequately greater than the wavelength of incident light" has been recommended as the general guideline for particle form in the thesis by Naganuma entitled "Development of glass particle-dispersed epoxy optical composite materials" (Tamaki Naganuma, University of Tokyo thesis submitted in March 2002).

### Consideration 3

Japanese Patent No. 3364229 only mentions that "luminescent pigment powder particularly with d₅₀ value of 5 µm or less has a noticeable agglomeration action" as the characteristic of a fluorescent material when its particle size is small, and does not mention anything in particular about the disadvantages other than the agglomeration action. Furthermore, no other known documents exist that give the lower limits of particle size. However, the inventors of the present invention, after grinding the powdered fluorescent material to finer powder in a planetary ball mill, used said powder in the manufacture of white LED lamp, and measured its brightness. It was found that when the fluorescent material particle size was very small and in the range of sub-micron level to about 1 µm, and when these particles were used, the intensity of light emitted from the white LED lamp decreased noticeably. Specifically, the brightness measured in front of the bullet-shaped white LED lamp reduced to as much as one-fifth of the original brightness.

One of the causes may be that the condition of the surface of powdered fluorescent material deteriorated because of ball mill grinding. The drop in excitation efficiency may also be one cause, but since the particle size of the fluorescent material is about the same as that of the wavelength of visible light, Mie scattering might be considered a cause. Mie scattering refers to the phenomenon of change in direction of advance of light without change in its wavelength or energy when light passes through a medium that includes particles (scatterer) of approximately the same size as the wavelength.

The particle scattering parameter χ that represents the characteristics of particle scattering of light may be given by the equation χ=πD/λ when the particle size is D, and the wavelength of light is taken as λ. When the particle scattering parameter χ mentioned above is a single-digit number, then the Mie scattering characteristics are indicated (refer to International Patent Publication WO 02/006859, for example), and if the wavelength of visible light is between 400 to 700 nm, then the range of particle sizes D at which the particle scattering parameter lies between 1 to 9 is 0.13 to 2.0 µm.

The equation stating Mie scattering has been derived by electromagnetically resolving the mutual interaction between light as electromagnetic wave, and the particles, and it can be used for general powder dispersion systems (refer to "Phosphor Handbook," Japanese Edition, edited by Phosphor Research Society, 1987, pp. 172-173, p. 395).

When Mie scattering occurs, the excitation light does not penetrate the fluorescent material particles, and is reflected from the surface of the particles. In such cases, the fluorescent material cannot adequately demonstrate its function as a wavelength-converting material, and the excitation light, the wavelength of which has not been converted, scatters in various directions. The scattering due to a fluorescent material is described in Japanese Patent No. 3364229 as follows: "the inorganic light-emitting substance YAG: Ce has a special advantage that it is an insoluble color pigment having a refractive index of about 1.84. As a result, dispersion and scattering effects occur in addition to the wavelength conversion, and the mixing of blue diode beam and yellow converted beam improves." Thus, the point that the scattering effect is an advantage has only been reported.

However, if the complex scattering occurs, the blue light emitted from the blue LED element, which should pass through the fluorescent material-dispersed resin layer and the yellow light emitted from the fluorescent material take a very complex path up to the white LED lamp outside. In this path, the emission intensity decreases because of absorption by various kinds of materials (non-emission absorption of the fluorescent material itself can be considered), which could probably lead finally to a drop in the light extraction efficiency.

### Conclusions

From Considerations 1 to 3 mentioned above, a white LED lamp, which is a device used for visible wavelength light passing through a fluorescent material-dispersed resin layer in which the powdered fluorescent material is densely dispersed in a transparent resin, has to satisfy the two requirements below.
Requirement 1: The process for applying the fluorescent material-dispersed resin is performed easily without any problems;
Requirement 2: Fluorescent material performs wavelength conversion of excitation light at the appropriate proportion according to optical design. Within the scope of these two requirements, the reduction in scattering as far as possible by powdered fluorescent material particles can improve the transmittance of visible wavelength light of the fluorescent material-dispersed resin layer. It can be concluded that this will enhance the light extraction efficiency of white LED lamp, and lead to improvement.

To enhance the luminous efficacy of white LED lamp with the equivalent simple and inexpensive construction as the conventional white LED lamp, and to improve the visible light transmittance of the fluorescent material-dispersed resin layer, it is important to selectively remove small particles with a particle size of about 2 to 3 µm or less from the powdered fluorescent material, and to inhibit the occurrence of Mie scattering as far as possible.

Secondly, it is preferable that the particle size of powdered fluorescent material be as large as possible in the geometric optical region in which the particle size is adequately larger than the wavelength of incident light. More specifically, it is important that the particle size be of the order of several tens of microns or greater, and to select a particle size at the upper limit of the size that satisfies the Requirement 1 mentioned above.

Thirdly, the particle surface area per unit volume is preferably small. Thus, it is important to select particles of a shape close to the spherical shape. With regard to the third point, the particle surface area per unit surface area can be made small even by making the particle volume fraction adequately small; but if Requirement 2 mentioned above is to be satisfied and if the dimensions of the device are to be made small, it becomes difficult to make the particle volume fraction adequately small.

To realize the target of enhancing the luminous efficacy of white LED lamp while retaining a simple and inexpensive structure equivalent to the conventional white LED lamp, the powdered fluorescent material of the present invention is characterized by a powdered fluorescent material that is activated by visible light and emits visible light, in which the content of particles with particle sizes of 20 µm or less is below 2% by mass. If the content of particles with particle sizes of 20 µm or less is made below 2% by mass, the occurrence of Mie scattering can be suppressed, the visible light transmittance of the fluorescent material-dispersed resin layer can be enhanced, and the light extraction efficiency of the white LED lamp can be improved. If the content of particles with particle sizes of 20 µm or less becomes greater than 2% by mass, Mie scattering occurs, visible light transmittance of the fluorescent material-dispersed resin layer decreases, and the light extraction efficiency of the white LED lamp decreases.

The powdered fluorescent material of the present invention preferably has a median particle size of not less than 30 µm and not more than 80 µm. In the present specification, the median size refers to the central value of the particle size distribution of the powder. When the median particle size becomes smaller than 30 µm, the content of particles with particle sizes of 20 µm or less increases, the visible light transmittance of the fluorescent material-dispersed resin layer due to Mie scattering decreases, which may lead to a reduction in the light extraction efficiency of the white LED lamp. On the other hand, if the median particle size exceeds 80 µm, the particle size becomes excessively large, and this may cause hindrance to the placement process for applying the fluorescent material-dispersed resin layer.

In the preferred embodiment of powdered fluorescent material of the present invention, a 90% particle size of the powdered fluorescent material is preferably 100 µm or less. In the present specification, the 90% particle size refers to the size of the particles at which the cumulative weight becomes 90% (d₉₀). If the 90% particle size exceeds 100 µm, the particle size becomes excessively large, and this may cause hindrance to the placement process for applying the fluorescent material-dispersed resin layer.

Additionally, for this a powdered fluorescent material, a 10% particle size is preferably 30 µm or more, and the median particle size is preferably not less than 40 µm and not more than 70 µm. In the present specification, the 10% particle size refers to the diameter of the particles at which the cumulative weight becomes 10% (d₁₀). If the 10% particle size is less than 30 µm and the median particle size is less than 40 µm, the content of the fine particles increases, which may lead to a decrease in the visible light transmittance of the fluorescent material-dispersed resin layer, and a decrease in the light extraction efficiency of the white LED lamp. On the other hand, if the median size exceeds 70 µm, this may makes the placement process for applying the fluorescent material-dispersed resin layer difficult.

The powdered fluorescent material of the present invention is excited by the visible light and emits visible light, and if it satisfies the particle size conditions mentioned above, it is satisfactory and there are no limitations on its composition.

In the preferred embodiment of the powdered fluorescent material of the present invention, said powdered fluorescent material is preferably excited by blue light, and preferably emit visible light in the range between bluish green light and red light. Particularly, a yellow fluorescent material that is excited by blue light and that emits light in the yellow color range is preferred. A light-emitting device that emits white light can be configured by combining blue excitation light and yellow fluorescent material.

The powdered fluorescent material of the present invention is preferably an oxynitride fluorescent material or a nitride fluorescent material. Additionally, the powdered fluorescent material of the present invention, is preferably a SiAlON activated by europium (particularly Eu²⁺), furthermore, the SiAlON is preferably calcium α-SiAlON. The calcium α-SiAlON activated by this divalent europium, is generally expressed by the general formula: CaₚSi₁₂₋₍ₘ₊ₙ₎A1ₘ₊ₙOₙN₁₆₋ₙ: Eu2⁺_{q}

By setting the content of particles with particle sizes of 20 µm or less to below 2% by mass in the powdered fluorescent material of the present invention, and by dispersing the particles in a transparent material, such as a transparent resin, the Mie scattering can be suppressed; the visible light transmittance of the fluorescent material-dispersed resin layer can be enhanced when providing it in a light-emitting device such as white LED lamp, and the light extraction efficiency of a light-emitting device such as white LED lamp can be improved.

The present invention also provides a method for manufacturing a powdered fluorescent material, comprising the steps of: chemically processing in an acid solution the raw material powder of the fluorescent material after sintering it when manufacturing the powdered fluorescent material, as the preferred method for manufacturing a powdered fluorescent material according to the present invention mentioned above.

The method for manufacturing a powdered fluorescent material of the present invention is widely applicable to powdered fluorescent materials manufactured after sintering a raw material powder of a fluorescent material, but particularly, a nitride or oxynitride fluorescent material activated by rare-earth elements is preferred, among others, and calcium α-SiAlON activated by divalent europium expressed by the general formula CaₚSi₁₂₋₍ₘ₊ₙ)A1ₘ₊ₙOₙN₁₆₋ₙ:Eu²_{q} is preferred. The method for manufacturing a powdered fluorescent material including calcium α-SiAlON activated by divalent europium is described below as the first embodiment of the method for manufacturing the present invention.

The raw material powder of the fluorescent material used in the present embodiment is preferably a compound powder, such as silicon nitride (Si₃N₄), aluminum nitride (AIN), calcium carbonate (CaCO₃), europium oxide (Eu₂O₃), for example, which can be used appropriately in combination with compounds that include various elements that constitute the calcium α-SiAlON activated by divalent europium. These raw material powders are to be weighed and mixed homogeneously so that the composition of powdered fluorescent material to be manufactured is obtained. These raw material powders are preferably wet mixed using a ball mill or the like after addition of ethanol or the like.

The wet-mixed raw material powder is preferably dried adequately using an evaporator or the like, sieved using a sieve of a nominal mesh size of 40 µm to 200 µm, subjected to vibration or impact, and is subjected to the granulating process to obtain agglomerate of said raw material powder passed through the sieve mesh before it is sintered. A powdered fluorescent material with approximately the same size as the agglomerate can be obtained after sintering by performing this granulation. The sieve used in the granulation is preferably a sieve with a nominal mesh size of about two times the median particle size of powdered fluorescent material to be manufactured. The agglomerate of the raw material powder from the granulation process is stored gently in a container for sintering.

Next, the container in which the agglomerated of the granulated raw material powder is stored is inserted in a sintering furnace, and said powder is sintered in a pressurized nitrogen atmosphere between 1600 and 1900°C, preferably between 1700 and 1800°C, for a period of 10 to 100 hours, preferably for a period of 20 to 48 hours. By sintering, the elements in the mixture of raw material powder react under the pressurized nitrogen atmosphere, and fluorescent material is formed from calcium α-SiAlON activated by divalent europium.

After sintering, the container is removed from the sintering furnace, the sintered substance obtained is broken down, if necessary, then placed in an acid solution and stirred. The powder after sintering is chemically treated in an acid solution, the glassy substance on the surface of the powdered fluorescent material is dissolved, and at the same time, fine particles are dissolved and removed. An acid mixture solution including hydrofluoric acid, sulfuric acid, and water, for instance, may be preferably used as the acid solution in the chemical treatment. The mixed acid solution can dissolve the fine particles and the glassy substance on the surface of the powdered fluorescent material.

The acid concentration in the acid solution and the treatment time of this chemical treatment process are preferably set such that the fine particles and the glassy substance on the surface of the powdered fluorescent material are dissolved, while powdered fluorescent material of a larger particle size is not dissolved. For instance, an acid solution prepared by mixing 5 ml of hydrofluoric acid of 46.0 to 48.0% concentration, 5 ml of sulfuric acid of concentration greater than 95%, and 390 ml of pure water maybe used, and the powder after sintering may be placed in this solution and chemically treated while stirring it for about 30 minutes.

After the acid treatment, the stirrer is stopped and the stirred solution allowed to stand still for about 30 minutes. Powdered fluorescent material of the desired particle size is allowed to settle, and the acid solution is sucked and removed such that the settled particles are not sucked away, such as with a dropping pipette before the fine particles have settled down. When the solution no longer exists, pure water is again added, and this water washing is performed several times.

Furthermore, the washed powdered fluorescent material is dispersed in pure water, washed while applying ultrasonic waves, and allowed to stand for about 30 seconds. The powdered fluorescent material of the desired size settles down, and the water is sucked and removed such that the settled down fluorescent material is not sucked away, such as with a dropping pipette before the fine particles have settled down.

The washed powdered fluorescent material is separated from water by filtering or by centrifugal separation, and it is dried.

By performing the processes mentioned above, a powdered fluorescent material made of calcium α-SiAION and activated by divalent europium in which the content of particles with particle sizes of 20 µm or less is a below 2% by mass can be obtained.

According to this method for manufacturing a powdered fluorescent material, when manufacturing the powdered fluorescent material after sintering a raw material powder of the fluorescent material; the fine particles, such as particles with particle sizes of 20 µm or less are dissolved by performing the step in which the powder after sintering is chemically treated in an acid solution. The glassy substance on the surface of the powdered fluorescent material dissolves and the particles dissociate. It becomes difficult for fine particles to adhere to the powdered fluorescent material of the desired particle size and to remain. By washing the powdered fluorescent material after the chemical treatment, only the fine particles can be easily removed by washing. This enables a powdered fluorescent material with a low content of fine particles to be manufactured with good efficiency.

Additionally, the present invention provides a light-emitting device comprising a semiconductor light-emitting element emitting visible light, and said powdered fluorescent material according to the present invention disposed so as to emit fluorescent light activated by visible light emitted from said semiconductor light-emitting element.

The embodiment of the light-emitting device of the present invention is described below with reference to the drawings. In the present embodiment, a white LED lamp comprising blue LED element used as a semiconductor light-emitting element, and powdered fluorescent material of various particle sizes formed by calcium europium-activated α-SiAlON mentioned above and used as powdered fluorescent material, is illustrated.

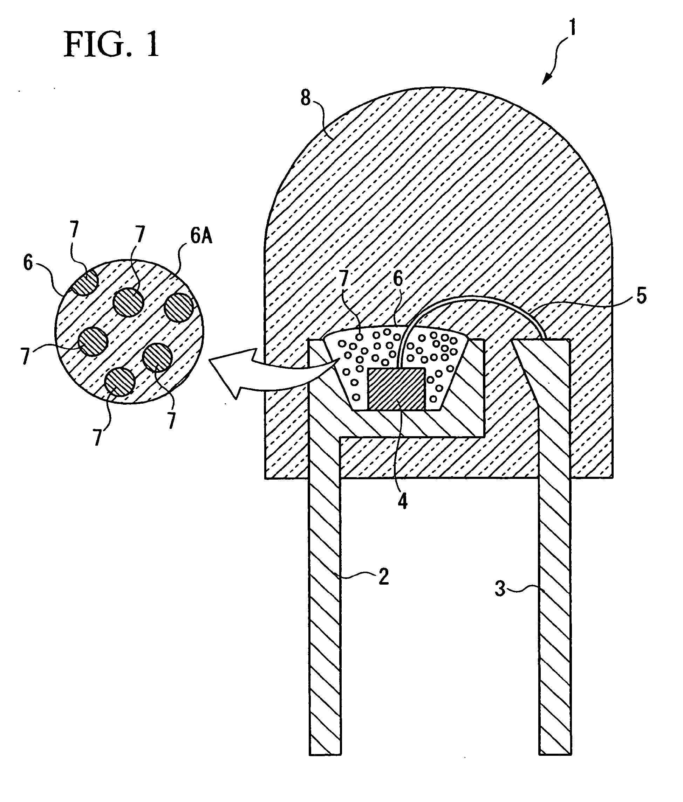

FIG. 1 shows a cross-sectional view of the first embodiment of the white LED lamp according to the present invention. In FIG. 1, reference numeral 1 is a bullet-shaped white LED lamp, reference numerals 2 and 3 are lead wires, reference numeral 4 is a blue LED element (light-emitting element), reference numeral 5 is a bonding wire, such as a thin metallic wire, reference numeral 6 is a fluorescent material-dispersed resin layer, reference numeral 6A is a transparent resin, reference numeral 7 is a powdered fluorescent material, and 8 is a molding resin.

The white LED lamp 1 comprises the two lead wires 2 and 3. A recess is formed in one lead wire 2, and the blue LED element 4 is placed in this recess. The lower electrode provided on the underside of this blue LED element 4 is coupled to the bottom surface of the recess of the lead wire 2. The upper electrode provided on the upper surface of the blue LED element 4 is electrically connected to the other lead wire 3 through the bonding wire 5. The blue LED element 4 is covered by the fluorescent material-dispersed resin layer 6 filled in the recess. This fluorescent material-dispersed resin layer 6 comprises the transparent resin 6A in which the powdered fluorescent material 7 of various particle sizes mentioned above is uniformly dispersed. The tips of the lead wires 2 and 3 including the recess, the blue LED element 4, and the fluorescent material dispersed resin layer 6, are sealed by transparent molding resin 8, while the lower ends of the lead wires 2 and 3 protrude from the molding resin 8 and are exposed. The molding resin 8 has an approximately cylindrical shape on the whole, and its front end is molded to a bullet shape with a curved surface in the form of a lens.

The blue LED element 4 preferably emits blue light, but there are no limitations in particular on the material and construction of each of its layers. For instance, an element with a structure comprising a light-emitting layer of indium gallium nitride (InGaN) semiconductor formed on a silicon carbide (SiC) substrate, and electrodes provided on its upper surface and lower surface can be used.

When voltage is applied between the two lead wires 2 and 3 of this white LED lamp 1 and blue light is made to be emitted from blue LED element 4, a part of this blue light is absorbed by the powdered fluorescent material 7 in the fluorescent material-dispersed resin layer 6, the powdered fluorescent material 7 is excited and yellow light is emitted. Mixed light of the remainder of the blue light and the yellow light emitted from powdered fluorescent material 7 pass through the fluorescent material-dispersed resin layer 6 and the molding resin 8, and are emitted outside the lamp. Since this blue light and yellow light have a complementary relationship, white light of high brightness is emitted from the lamp. The chromaticity of the mixed light can be adjusted by the quantity of powdered fluorescent material 7. More specifically, the quantity of the fluorescent material-dispersed resin layer 6 to be applied in which the powdered fluorescent material 7 is uniformly dispersed, is adjusted such that the chromaticity coordinate of said mixed light coincides with the black body radiation locus.

The present embodiment comprises a fluorescent material-dispersed resin layer 6 in which the powdered fluorescent material 7 having particles with particle sizes of 20 µm or less at a content of below 2% by mass is dispersed. This suppresses the Mie scattering in the fluorescent material-dispersed resin layer 6, and enhances the visible light transmittance of the fluorescent material-dispersed resin layer 6. As a result, the present embodiment can provide a white LED lamp 1 with excellent light extraction efficiency.

The white LED lamp 1 of the present embodiment may be manufactured, for instance, using the processes described below.
(1) Firstly, the blue LED element 4 in the recess provided for placement of element in the lead wire 2, is die bonded using a conductive paste.
(2) Next, the upper electrode 8 of the blue LED element 4, and the other lead wire, 3 are die bonded with a thin metallic wire.
(3) Next, the fluorescent material-dispersed resin in which the powdered fluorescent material 7 is dispersed, is filled in the recess so that it covers the blue LED element 4, cured, and the fluorescent material-dispersed resin layer 6 is formed.
(4) Next, the major parts of the white LED lamp 1 are surrounded by a transparent molding resin 8 such as epoxy resin and the resin is cured.

The white LED lamp 1 shown in FIG. 1 is manufactured by the manufacturing method described above. The transparent resin 6A and the molding resin 8 used in the preparation of the fluorescent material-dispersed resin layer 6 during the manufacture of white LED lamp 1 may be the same resin or may be different resins.

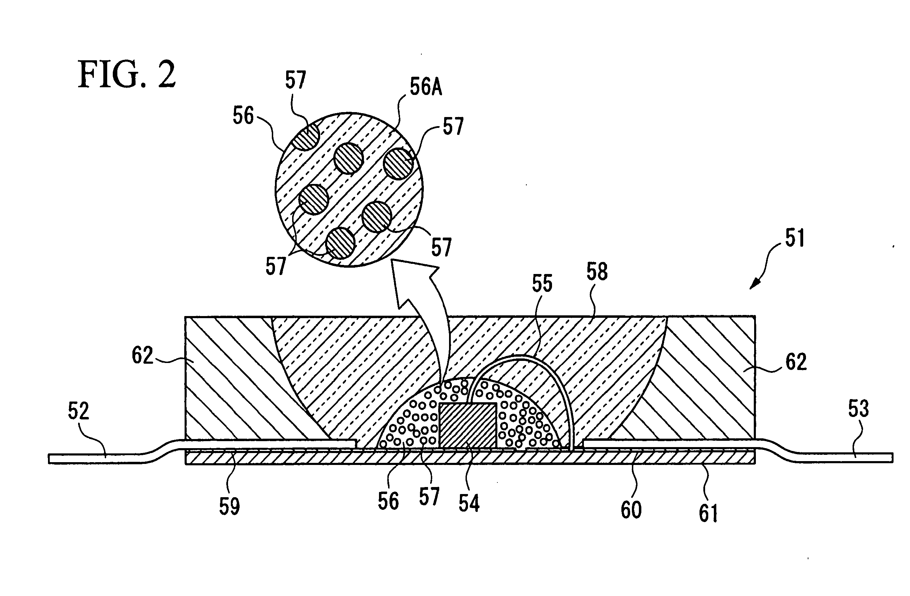

FIG. 2 is a cross-sectional view showing another embodiment of the white LED lamp according to the present invention. In FIG. 2, the reference numeral 51 is a chip-type white LED lamp, reference numerals 52 and 53 are lead wires, reference numeral 54 is a blue LED element (light-emitting element), reference numeral 55 is a bonding wire, such as a thin metallic wire, reference numeral 56 is a transparent resin, reference numeral 57 is a powdered fluorescent material, reference numeral 58 is a sealing resin, reference numerals 59 and 60 are electrode patterns, reference numeral 61 is a support substrate, and reference numeral 62 is a wall member with a recess.

The chip-type white LED element 51 of the present embodiment comprises the multiple electrode patterns 59 and 60 made of a conductive material and formed on the support substrate 61. The lead wires 52 and 53 are connected electrically to the electrode patterns 59 and 60, respectively, and the blue LED element 54 is die bonded on one electrode pattern 59. This electrode pattern 59 and the lower electrode of the blue LED element 54 are electrically connected. The upper electrode of the blue LED element 54 and the other electrode pattern 60 are electrically connected through the die bonding wire 55 made of a thin electric wire. Furthermore, the blue LED element 54 is covered by the fluorescent material-dispersed resin layer 56.

The support substrate 61 comprises the wall surface member 62 with a bowl-shaped hole made of a material with high reflectivity of visible light rays, such as alumina ceramics, and arranged in such a manner as to accommodate blue LED element 54 and fluorescent material-dispersed resin layer 56 in said hole. Transparent sealing resin 58 is filled in the hole of wall surface member 62 to seal the blue LED element 54 and the fluorescent material-dispersed resin layer 56 in the hole.

The electrode patterns 59 and 60 on the support substrate 61 may be formed, for instance, by the sputtering method, in which the desired pattern of thin conductive metallic film, such as a copper film, is formed on the support substrate 61. The thickness of the electrode patterns 59 and 60 is of the order of a few microns, and practically no level difference exists between these patterns and the support substrate 61.

This fluorescent material-dispersed resin layer 56 comprises the transparent resin 56A in which the powdered fluorescent material 57 of various particle sizes mentioned above, is uniformly dispersed.

When voltage is applied between the two lead wires 52 and 53 of this white LED lamp 51 and blue light is made to be emitted from blue LED element 54, a part of this blue light is absorbed by the powdered fluorescent material 57 in the fluorescent material-dispersed resin layer 56, the powdered fluorescent material 57 is excited and yellow light is emitted. Mixed light of the remainder of the blue light and the yellow light emitted from the powdered fluorescent material 57 pass through the fluorescent material-dispersed resin layer 56 and the sealing resin 58, and are emitted outside the lamp. Since this blue light and yellow light have a complementary relationship, white light of high brightness is emitted from the lamp. The chromaticity of the mixed light can be adjusted by the quantity of powdered fluorescent material 57. More specifically, the quantity of the fluorescent material-dispersed resin layer 56 to be applied in which the powdered fluorescent material 57 is uniformly dispersed can be adjusted such that the chromaticity coordinate of said mixed light coincides with the black body radiation locus.

The present embodiment comprises a fluorescent material-dispersed resin layer 56 in which the powdered fluorescent material 57 having particles with particle sizes of 20 µm or less at a content of below 2% by mass is dispersed. This suppresses the Mie scattering in fluorescent material-dispersed resin layer 56, and enhances the visible light transmittance of the fluorescent material-dispersed resin layer 56. As a result, the present embodiment can provide a white LED lamp 51 with excellent light extraction efficiency. Furthermore, when placing the chip-type white LED lamp 51 of the present embodiment on the substrate as an illumination device, it has the advantage that it can be mounted on the surface, unlike the bullet-shaped white LED lamp which needs a hole to be made in the substrate.

The white LED lamp 51 of the present embodiment may be manufactured, for instance, using the processes described below.
(1) The multiple electrode patterns 59 and 60 made of a conductive material, such as copper, are formed on the surface of the support substrate 61 by sputtering.
(2) The lead wires 52 and 53 are connected to the electrode patterns 59 and 60 by high melting point solder or the like.
(3) The wall surface member 62 made of alumina ceramics and with a bowl-shaped hole is mounted and fixed on the support substrate 61.
(4) The blue LED element 54 is placed on electrode pattern 59, and the lower electrode and the electrode pattern 59 are electrically connected by a conductive paste.
(5) After wire bonding, the blue LED element 54 and the other electrode pattern 60 are electrically connected through the bonding wire 55.
(6) A resin composition dispersed with the powdered fluorescent material 57 in the transparent resin 56A, such as epoxy resin, is coated so as to cover the blue LED element 54, allowed to cure and form the fluorescent material-dispersed resin layer 56.
(7) The transparent sealing resin 58, such as epoxy resin, is filled in the recess of the wall surface member and allowed to cure.

The step of (3) above can be performed before or after any of the processes from (4) to (6).
The step of (2) above can be performed at the same time with the step of (3).

The white LED lamp 51 shown in FIG. 2 is manufactured by the manufacturing method described above. The transparent resin 56A and the sealing resin 58 used in the preparation of the fluorescent material-dispersed resin layer 56 during the manufacture of white LED lamp 51 may be the same resin or may be different resins.

The present invention also provides an illumination apparatus with the light-emitting device according to the present invention, such as the white LED lamp shown in FIG. 1 or FIG. 2 mentioned above, as the light source. The illumination apparatus of the present invention can form a long life illumination apparatus, and can provide white light of high brightness at a small power consumption since it includes the white LED lamp mentioned above.

### Examples

### Experiment 1

A commercially available YAG-based fluorescent material that can be expressed by the general formula: (Y,Gd)₃Al₅O₁₂:Ce and which is commonly known as a fluorescent material for a white LED lamp, was provided. The activation peak wavelength and the light-emitting peak wavelength of this fluorescent material were 468 nm and 563 nm, respectively, and this powder had already been sized into a particle size of less than or equal to 10 µm. The median particle size (median size: the central value of the particle size distribution) of the fluorescent material measured using a laser diffraction/ dispersion type particle distribution measuring apparatus was 7.13 µm. Such particles were taken as Sample M. Sample M was dispersed in guaranteed reagent ethanol, and making use of the difference in precipitation speed, the particles were separated into particles of larger size (Sample L) and into particles of smaller size (Sample S).

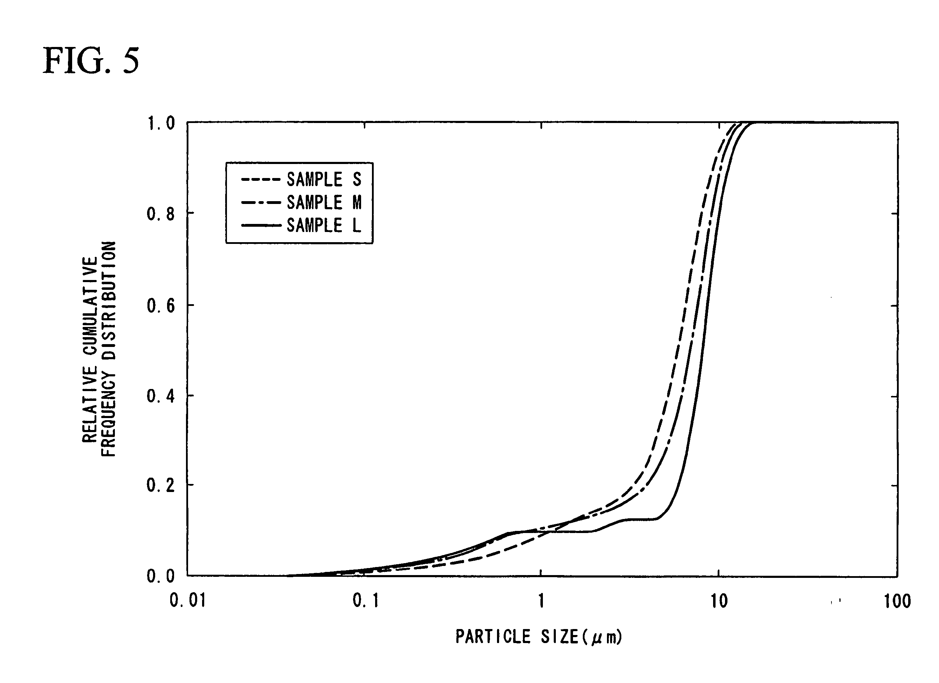

FIG. 5 shows particle distributions of Samples S, M, and L measured using the laser diffraction/ dispersion type particle distribution measuring apparatus. This figure shows the relative cumulative frequency distribution. The median particle sizes are 6.04 µm for Sample S, 7.13 µm for Sample M, and 8.34 µm for Sample L. The percentage of particle size between 0.1 to 2 µm, that is, less than or equal to 2 µm, calculated from the measured results above, was 13% by mass for Sample S, 12% by mass for Sample M, and 9% by mass for Sample L.

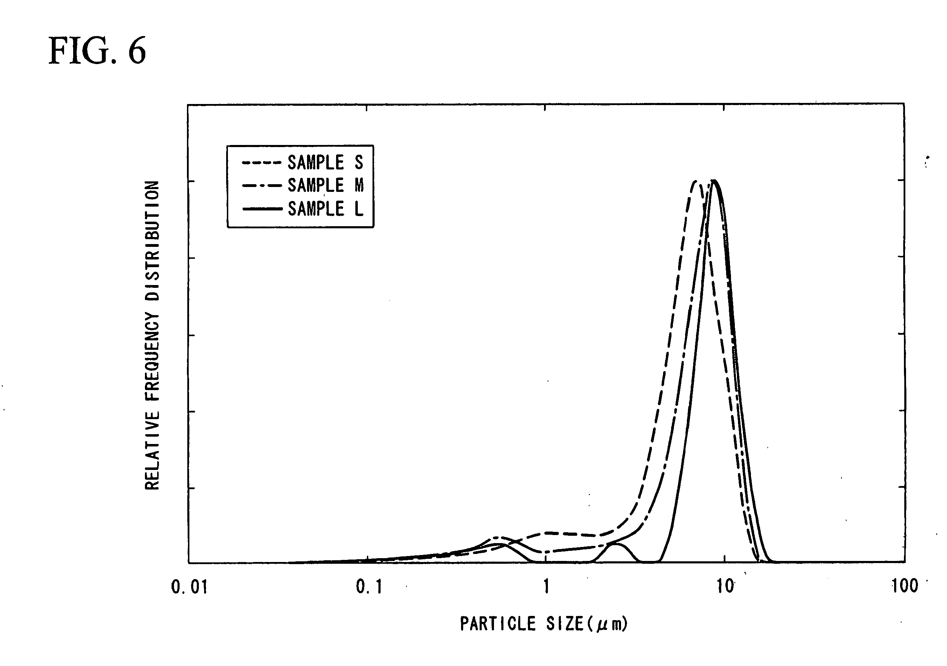

FIG. 6 shows the particle size distributions of Sample S, Sample M, and Sample L as frequency distributions. Each distribution in this figure has been normalized taking the range of particle sizes in which the frequency peaks, as the base. As shown in the figure, the particle composition of smaller size in Sample S is evidently higher compared to that of samples M and L. On the other hand, there is no major difference in the particle composition of larger size in samples M and L. The distribution of Sample L indicates that particles of size less than 5 µm have been excluded from Sample M.

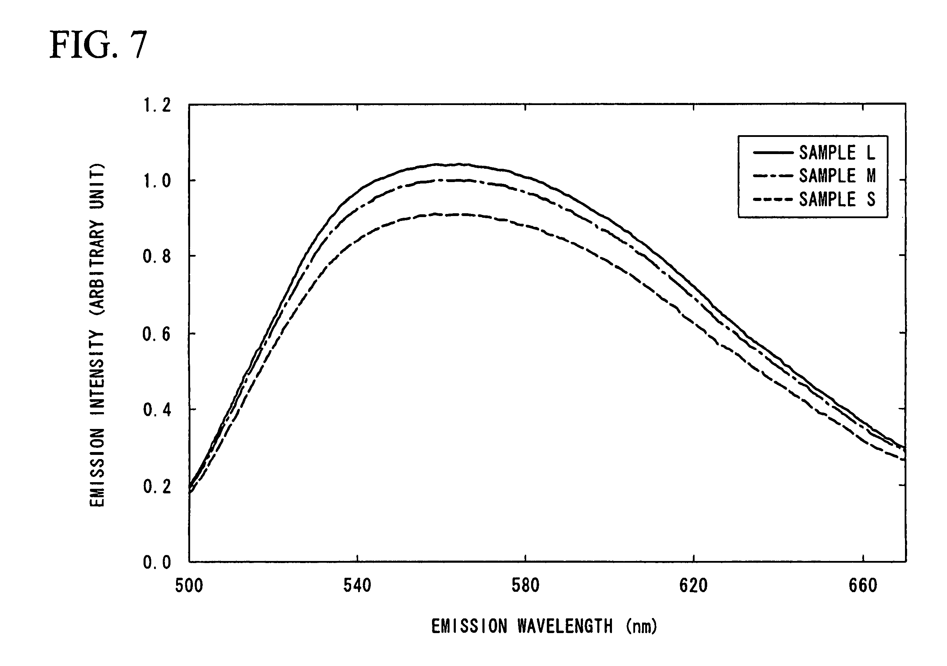

Next, with reference to FIG. 7, emission intensities from Samples S, M, and L measured by a fluorescence spectrophotometer are described here. Excitation wavelength was selected as 460 nm assuming that a blue LED element will be used. The emission intensities shown in the figure are normalized values taking the intensity of light emitted at the emitted peak wavelength of Sample M as 1. The results of measurement mentioned above verified that the emission intensity improved by 4% in case of Sample L and dropped by 9% in case of Sample S. The point to be noted here is that Sample L is the remainder obtained after removing Sample S from Sample M. That is, it was confirmed that the luminous efficiency of powdered fluorescent material could be enhanced by selectively removing fine particles only. As mentioned above, since no other process except selective removal of fine particles from the powdered fluorescent material was performed in this experiment, and particles that contributed to emission of light in Sample L were the same as those in Sample M. Thus, it is evident that the fine particles (Sample S) selectively removed from Sample M have caused degradation of luminous efficacy or degradation of light extraction efficiency after emission of light outside.

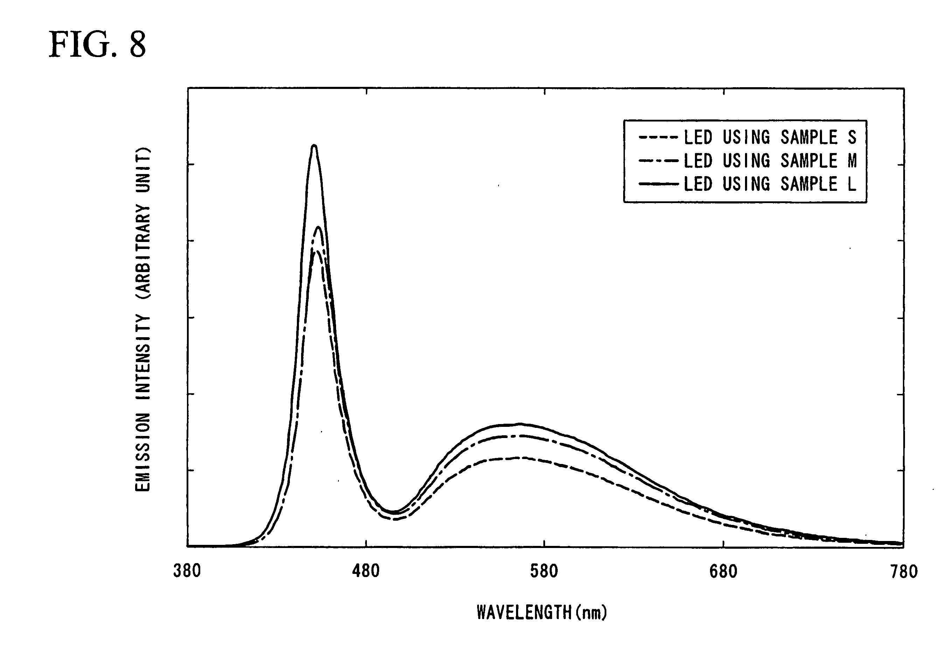

To validate the above, the same bullet-shaped white LED lamps shown in FIG. 4 were made using powdered fluorescent materials from samples S, M and L mentioned above, and the brightness in front of each of the white LED lamps was measured using an ultraviolet and visible light spectrophotometer. FIG. 8 shows the results of the measurement. Not only did the intensity of yellow light emitted by the sample in the white LED lamp provided with Sample L become greater than that emitted by the white LED lamp provided with Sample M, but at the same time, the intensity of blue light transmitted also increased. This indicates that the light extraction efficiency in the light-emitting diode has improved significantly by selectively removing small particles of size between 2 to 3 µm from fluorescent material. On the other hand, not only did the intensity of yellow light emitted by the sample in the white LED lamp provided with Sample S decrease greater than that emitted by the white LED lamp provided with Sample M, but at the same time the intensity of blue light transmitted also decreased. From this experiment, the Sample L mentioned above can be determined as appropriate for the powdered fluorescent material to be used in white LED lamps.

### Experiment 2

Three samples (Sample 2A, Sample 2B, and Sample 2C) of an α-SiAlON yellow fluorescent material were prepared by the procedure described below. Each of these samples was used in white LED lamps manufactured for tests and evaluated.

Calcium α-SiAlON activated by divalent europium is generally expressed by the general formula: CaₚSi₁₂₍ₘ₊ₙ₎Alₘ₊ₙOₙN₁₆₋ₙ: Eu²⁺_{q} For this experiment the following values were taken: p = 0.875, q=0.0833, and m and n were determined according to p and q as follows: m=1.9999, n=0.99995. Accordingly, the composition was Ca_{0.875}Si_{9.00015}Al_{2.99985}O_{0.99995}N_{15.00005}:Eu²⁺_{0.0833}.

Silicon nitride (Si₃N₄), aluminum nitride (AIN), calcium carbonate (CaCO₃), and europium oxide (Eu₂O₃) were used as the starting materials. According to the composition design mentioned above, 32.570 g of silicon nitride, 9.515 g of aluminum nitride, 6.780 g of calcium carbonate, and 1.135 g of europium oxide were weighed out on an electronic balance so that each batch weighed 50 g, and the composition was mixed for 2 hours in a wet planetary ball mill. The composition was dried in a rotary evaporator, and in the dried condition, it was broken down adequately using a mortar. The powder was granulated to an appropriate particle size using a sieve for experiments made of stainless steel mesh of nominal size 125 µm compliant with JIS Z 8801, and gently stored in a container with lid made of boron nitride. Next, the container with the powder was inserted in a sintering furnace, and it was sintered under a gas pressure of 5 atms in a nitrogen atmosphere at 1700°C. The sintering time was set to 24 hours. After sintering, when the powder was removed from the apparatus, the sintered substance that had hardened to lumps in the container, was broken down to powder by applying a slight pressure in the mortar.

From this powder, particles with a particle size of 45 µm or less were separated using a sieve with stainless steel mesh of nominal size 45 µm made for experiments and compliant with JIS Z8801, and these particles were taken as Sample 2B.

The remaining powder with particle sizes of 45 µm or greater were sized into powder of particles with particle sizes of 63 µm or less using a stainless steel sieve of nominal mesh size 63 µm made for experiments, and this powder was taken as Sample 2C.

The remainder of the powder with particle sizes of 63 µm or more was wet ground in a planetary ball mill. The container used was a silicon nitride container, the grinding medium was silicon nitride balls, and the solvent used was ethanol. The powder was ground at 150 rpm for 1 hour, passed through a stainless steel sieve with a nominal mesh size of 45 µm for experiments with ethanol, and wet classified. Particles that did not pass through the sieve were wet ground in a planetary ball mill for one hour, and then passed through the same sieve. The particles that passed through the sieve were taken in a beaker, allowed to stand until dry, and the powder was collected. Because of concern that the increase in defects due to ball mill grinding would cause the emission intensity to decrease, the dried powder was again heat treated in the gas pressurized sintering furnace with the aim of recovering the optical characteristics. The heat treatment conditions at this stage were 1600°C, nitrogen atmosphere of 5 atms, and a heating time of 4 hours. The obtained powder was taken as Sample 2A.

The particle distributions of all the samples, 2A, 2B, and 2C, were measured using the laser diffraction/ dispersion type particle distribution measuring apparatus (CILAS 1064 manufactured by Cilas). The median particle size, 10% particle size, and 90% particle size of Sample 2A were 16.11 µm, 4.41 µm, and 27.33 µm respectively. Generally, samples classified by sieve with stainless steel mesh of nominal size 45 µm for experiments have median particle size of 20 to 25 µm, therefore, Sample 2A was finer than Sample 2B.

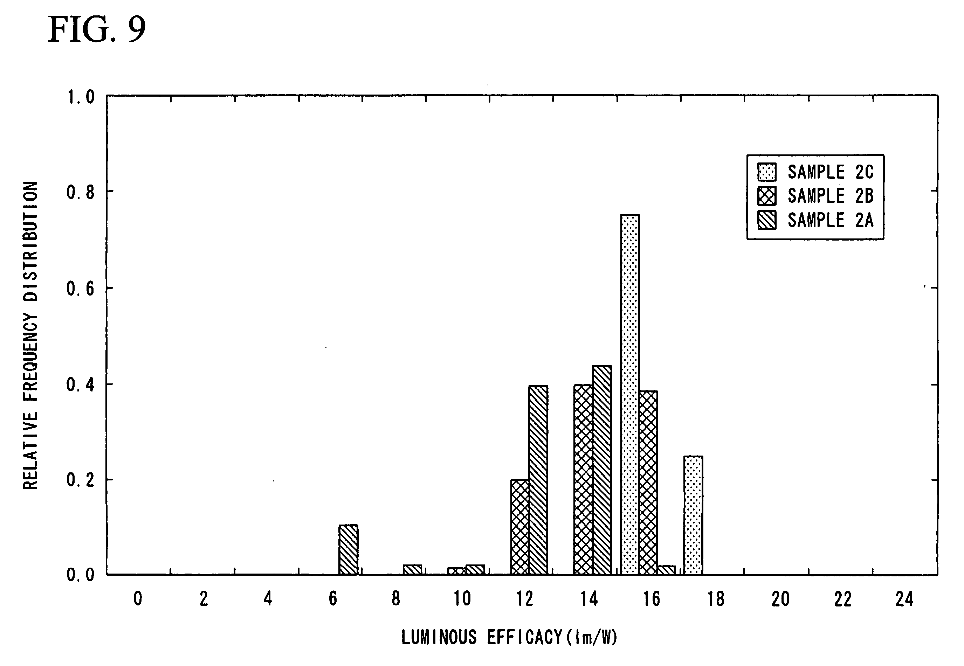

Using each of the samples 2A, 2B, and 2C, bullet-shaped white LED lamps similar to that in FIG. 4 were made, and their luminous efficacy was measured. The frequency distribution of the measured luminous efficacy is shown in FIG. 9. The mean luminous efficiencies (in Im/W) of the white LED lamps with Sample 2A, Sample 2B, and Sample 2C was 11.4 Im/W, 13.2 lm/W, and 15.6 lm/W respectively. The results suggested that the larger the particle size of the powdered fluorescent material, the higher the luminous efficacy of the white LED lamp.

### Experiment 3

Two samples (Sample FY10-45 and Sample FY10-63) of α-SiAlON yellow powdered fluorescent material were prepared using the procedure described below, and the samples were chemically treated.

The calcium α-SiAlON activated by this divalent europium, is generally expressed by the general formula: CaₚSi₁₂₋₍ₘ₊ₙ₎Alₘ₊ₙOₙN₁₆₋ₙ:Eu²⁺_{q} For this experiment the following values were taken: p = 0.88, q=0.05, and m and n were determined according to p and q as follows: m=1.91, n=0.955. Accordingly, the composition was Ca_{0.88}Si_{9.135}Al_{2.865}O_{0.955}N_{15.045}:Eu²⁺_{0.05}.

Silicon nitride (Si₃N₄), aluminum nitride (AlN), calcium carbonate (CaCO₃), and europium oxide (Eu₂O₃) were used as the starting materials. According to the composition design mentioned above, 33.295 g of silicon nitride, 9.150 g of aluminum nitride, 6.865 g of calcium carbonate, and 0.685 g of europium oxide were weighed out on an electronic balance so that each batch weighed 50 g, and the composition was mixed for 2 hours in a wet planetary ball mill. The composition was dried in a rotary evaporator, and in the dried condition, it was broken down adequately using a mortar. The powder was granulated to an appropriate particle size using a sieve for experiments made of stainless steel mesh of nominal size 125 µm compliant with JIS Z 8801, and gently stored in a container with lid made of boron nitride. Next, the container with the powder was inserted in a sintering furnace, and it was sintered under a gas pressure of 5 atms in a nitrogen atmosphere at 1800°C. The sintering time was set to 24 hours. After sintering, when the powder was removed from the apparatus, the sintered substance that had hardened to lumps in the container was broken down to powder by applying a slight pressure in the mortar.

From this powder, particles with a particle size of 45 µm or less were separated using a sieve with stainless steel mesh of nominal size 45 µm made for experiments and compliant with JIS Z8801, and these particles were taken as Sample FY10-45. The remaining powder of particle size greater than 45 µm were sized into powder of particles with particle sizes of 63 µm or less using a stainless steel sieve of nominal mesh size 63 µm made for experiments, and this powder was taken as Sample FL10-63.

Next, 5g each of Sample FY10-45 and Sample FY10-63 were taken and these samples were chemically treated to remove the glass phase on the surface and at the interface. More specifically, the dissolution process was performed using an acid solution prepared from hydrofluoric acid, sulfuric acid, and water. Five milliliters of hydrofluoric acid (HF), 5 ml of sulfuric acid (H₂SO₄), and 390 ml of pure water were mixed in a fluororesin beaker, and stirred for 5 minutes in a fluororesin magnetic-type stirrer. The hydrofluoric acid used as a guaranteed reagent made by Wako Pure Chemical Industries, Ltd. had a concentration of 46.0 to 48.0%, while the sulfuric acid was Wako Grade 1 made by Wako Pure Chemical Industries, Ltd. with a concentration of 95.0% or higher. Five grams of Sample FY10-45 was placed in this acid solution, and the mix was stirred for 30 minutes using a stirrer. After stirring, the solution was allowed to stand still for 30 seconds, the acid solution was removed using a dropping pipette taking care not to suck the settled down powdered fluorescent material, and when the solution was fully removed, pure water was again added and the powder was washed in this manner five times. Water was again added to the beaker, and ultrasonic waves were applied in the ultrasonic tank for 15 minutes. The transparent water became white and turbid. The solution was allowed to stand still for 30 seconds, the water was removed using a dropping pipette taking care not to suck the settled down powdered fluorescent material, and when the solution was fully removed, pure water was again added and the powder was washed in this manner five times. Finally, the powder was extracted using a filter paper, dried and taken as a sample after chemical treatment of Sample FY10-45.

The same chemical treatment was performed for Sample FY10-63, and it was selected as a sample after chemical treatment of Sample FLY 10-63.

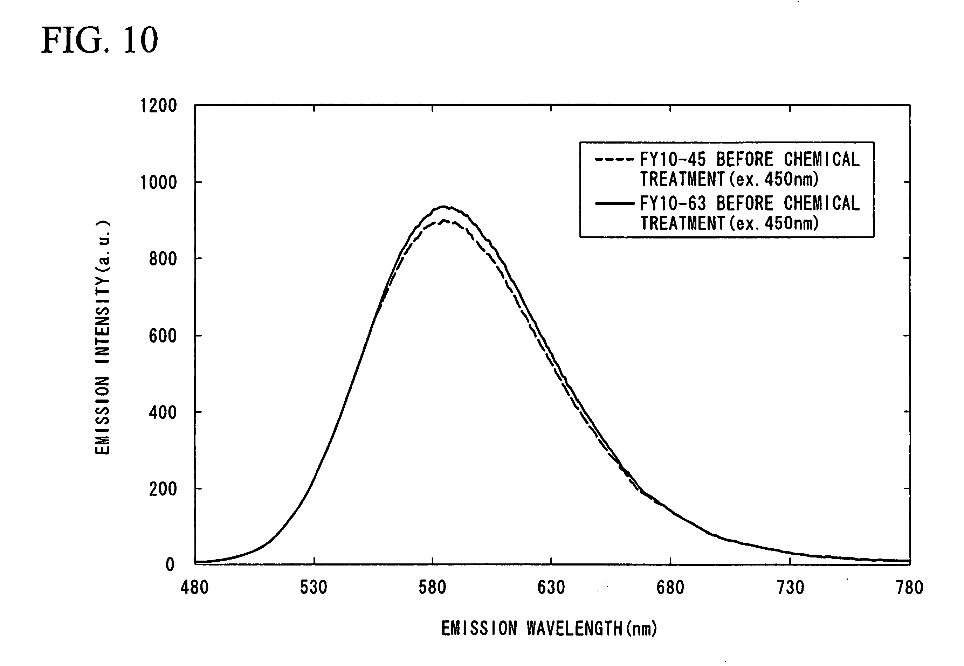

FIG. 10 shows the emission spectra of FY10-45 and FY10-63 samples before the chemical treatment, measured with a fluorescence spectrophotometer (F-4500 manufactured by Hitachi, Ltd.). The excitation wavelength was 45 nm. From FIG. 10, it can be observed that Sample FY10-63 is about 4% brighter than Sample F10-45 in terms of the peak emission intensity.

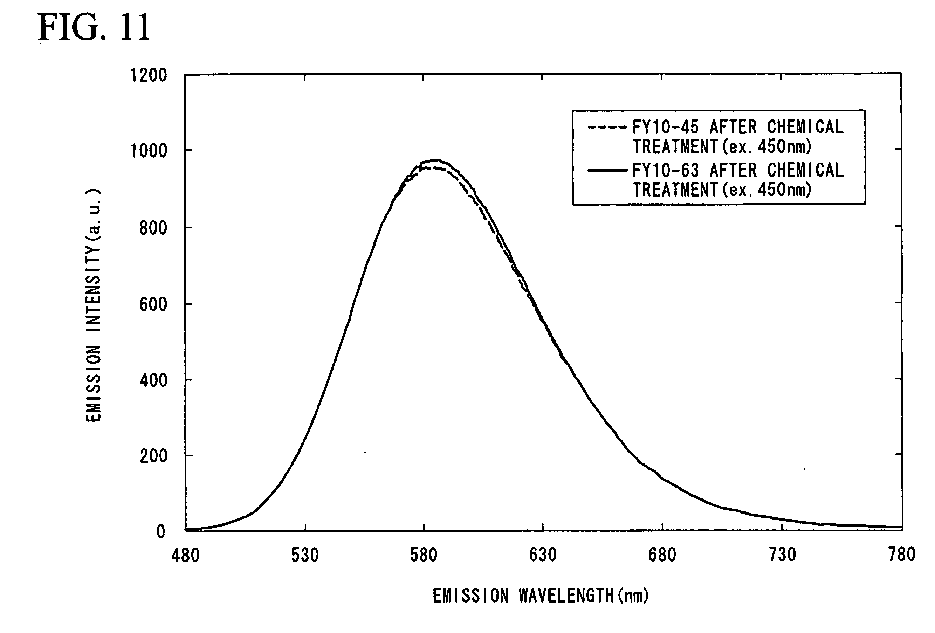

FIG. 11 shows the emission spectra of Samples FY 10-45 and FY 10-63 after the chemical treatment, measured in a similar manner. From FIG. 11, it can be observed that Sample FY10-63 is about 2% brighter than Sample F10-45 in terms of the peak emission intensity.

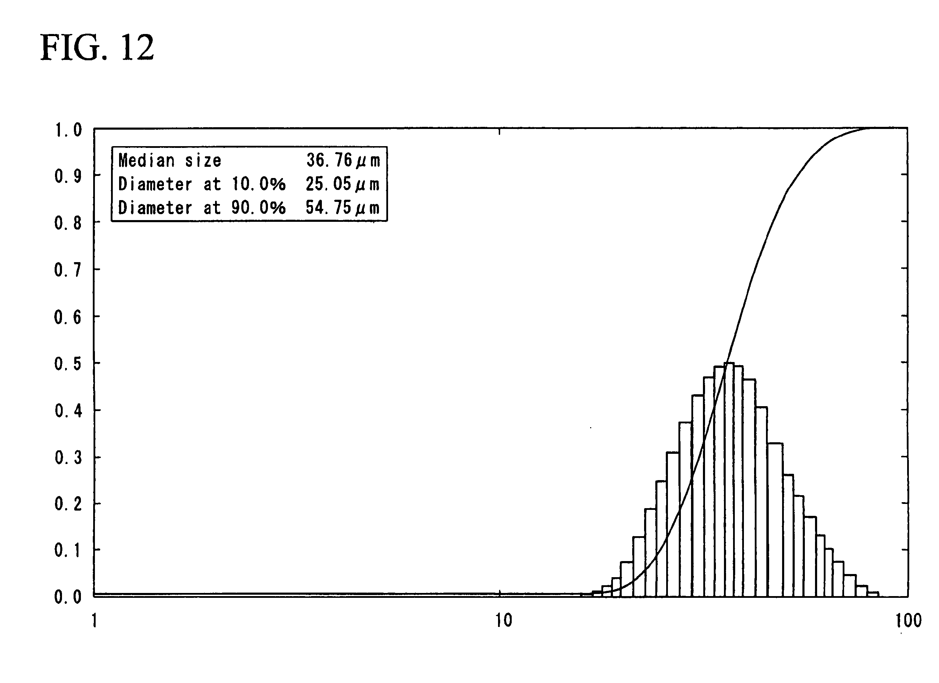

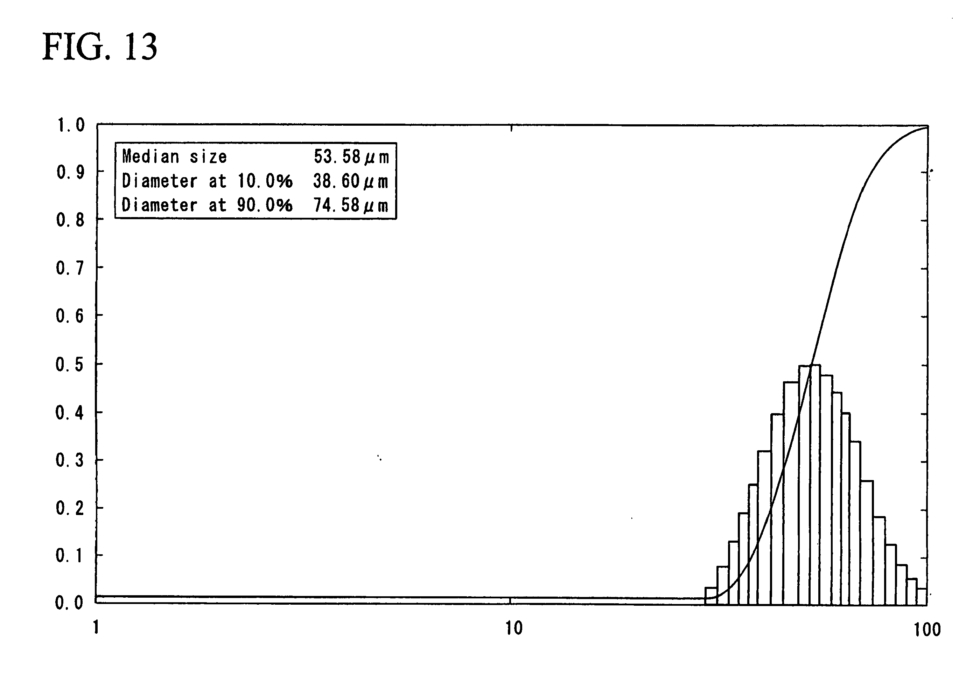

FIG. 12 and FIG. 13 show the particle size distributions of Samples FY10-45 and FY 10-63, respectively, after the chemical treatment, measured by with laser diffraction/ dispersion type particle distribution measuring apparatus (CILAS 1064 manufactured by Cilas).

From FIG 12, the median particle size is 36.76 µm, the 10% particle size is 25.05 µm, and the 90% particle size is 54.75 µm for Sample FY10-45 after the chemical treatment. Furthermore, the cumulative frequency distribution shows that the percentage of particles with particle sizes of 20 µm or less is below 2%.

From FIG. 13, the median particle size is 53.58 µm, the 10% particle size is 38.60 µm, and the 90% particle size is 74.58 µm for Sample FY10-63 after the chemical treatment. Furthermore, the cumulative frequency distribution shows that the percentage of particles with particle sizes of 32 µm or less is below 2%.

From the results of these particle distribution measurements, it can be observed that fine particles of size same as the wavelength of light that can cause Mie scattering are not substantially included in both samples after the chemical treatment. It was also observed that particles of a median size of about 54 µm were brighter by about 2% than particles of a median size of about 37 µm when these particles were used in a white LED lamp.

The contribution of chemical treatment to removal of fine particles was large. Firstly, fine particles dissolve in acid together with the dissolution of glass phase. Not all acid solutions may be satisfactory; the particular acid solution used in the present invention is preferable because both glass phase and SiAlON are dissolved. Secondly, since the acid solution or water is removed without waiting for a relatively long time while the fine particles are being suspended when removing the white turbid water after applying ultrasonic waves or removing the acid solution using the dropping pipette, the fine particles are likely to be removed together with the solution or water. Large particles settled down in a short time, therefore only fine particles can be removed. More specifically, the removal is preferably done in a few ten seconds to a few minutes after stirring or after applying the ultrasonic waves. If allowed to remain still for several ten minutes so that the supernatant liquid becomes transparent, then the result is that fine particles also settle down and remain in the powdered fluorescent material.

### Experiment 4

In the previous Experiment 3, Sample FY10 with particles of size greater than 63 µm that remained after separating and classifying Sample FY10-45 and Sample FLY10-63, was further classified by passing it through a sieve with nominal mesh size of 125 µm, and the powder that passed through the sieve was taken as Sample FY10-125.

Using this Sample FY10-125, an attempt was made to manufacture bullet-shaped white LED lamp similar to the one shown in FIG. 4, and the dispenser for applying fluorescent material-dispersed epoxy resin caused clogging and the resin could not be applied. Accordingly, the particle size of powdered fluorescent material of the order of a few ten microns was determined to be appropriate, and particle size of the order of a few hundred microns was determined to be too large.

### Experiment 5

A known conventional method of synthesizing α-SiAION powdered fluorescent material is to grind sintered pellets by mechanical means using the hot press method to powder (for instance, see Japanese Patent Application, First Publication No. 2002-363554 and R.-J. Xie, M. Mitomo, K. Uheda, F.-F. Xu, and Y. Akimune, "Preparation and Luminescence Spectra of Calcium- and Rare-Earth (R=Eu, Tb, and Pr)-Co-doped α-SiAION Ceramics," J. Am. Ceram. Soc., Vol. 85 [5], pp. 1229-1234 (2002)).

SiAlON pellets made of ceramic with a very high Mohs hardness value of 9 are ground in this method. Thus, the powder obtained has irregular shape with sharp corners, and it is difficult to say that the shape is approximately spherical. Furthermore, when the particles are dispersed in a transparent resin such as epoxy resin and cured by heating, residual stress occurs in the resin after curing because of the shrinkage rate when the resin cures or because of the difference coefficient of linear expansion of the resin and the particles. If these particles have sharp corners, stress concentration further occurs, and the change in refractive index of resin becomes larger. This kind of localized change in the refractive index of resin may lead to dispersion of light and is not preferred.

Several methods for manufacturing an α-SiAION fluorescent material in powder form have been disclosed in recent years. The gas pressurized sintering method is one such method, for instance the method described in R.-J. Xie, N. Hirosaki, M. Mitomo, Y. Yamamoto, T. Suehiro, K. Sakuma, "Optical Properties of Eu2+ in α-SiAlON," J. Phys. Chem. B, Vol.108, pp. 12027-12031 (2004). This reference reports how crystalline particles of 0.5 to 1.8 µm in collective form were obtained, and also gives scanning electron microscope (SEM) photos and results of measurement of particle distributions. The SEM photos show secondary particles formed by agglomeration of several primary particles, but it is difficult to say that the shape of the secondary particle is spherical. Moreover, the particles are distributed from the sub-micron range to 20 µm; the center of the particle distribution is in the range of 1 to 2 µm, and the particle size is too small and inadequate. To obtain particles of the order of several tens of microns, additional measures are necessary.

Another one is a technique disclosed in Japanese Patent Application, First Publication Nos. 2004-238505 and 2004-238506, which is characterized by the adjustment of oxygen content of nitrosilane compounds and/or amorphous silicon nitride powder, which are the starting materials, and the addition of α-SiAlON powder into the raw material powder prepared beforehand. However, even in the technique disclosed, the median particle size of the powder obtained is less than or equal to 8 µm; thus the particle size is too small and inadequate.

In view of this background, the inventors of the present invention, performed studies to obtain α-SiAlON fluorescent material particles of "close to spherical shape" with their own desired "particle method for particles of size greater than several tens of microns."

The results of the studies showed that when raw material powder is granulated to a constant particle size and sintered under gas pressure, the shape of the granulated particles is practically retained during sintering, and the studies proposed a process to granulate raw material powder to the order of several tens of microns with good efficiency. More specifically, as mentioned in the explanations of Experiment 3 above, the raw material powder was mixed using the wet-type ball mill for 2 hours, and after drying the raw material powder in a rotary evaporator, and in the dried condition, it was broken down adequately using a mortar. The powder was granulated to an appropriate particle size using a sieve for experiments made of stainless steel mesh of nominal size 125 µm compliant with JIS Z 8801, and gently stored in a container with lid made of boron nitride. The powder in the container was placed in a gas-pressurized sintering furnace and sintered under gas pressure. The granulation process using sieve is important here. If the powder is placed in the sieve and external force the sieve is applied, agglomerate of particles of size smaller than the nominal mesh size not only pass through the sieve, but also large-sized agglomerate breaks down into smaller particles when it strikes the mesh, the size becomes smaller and as a result, they are able to pass through the sieve. The final result is that powder that has passed through the sieve (granulated), shows a distribution of particle size that is centered about half the nominal mesh size. This means, for instance, that if the powder is granulated with a sieve of nominal mesh size is 125 µm, a distribution centered in the range of 60 to 70 µm can be obtained. Additionally, if granulated with a nominal mesh size of sieve of 63 µm, then a distribution centered around 20 to 40 µm can be obtained. The α-SiAlON fluorescent material obtained by after granulating the powder this way and sintering it, generally has the same particle size distribution. In the granulation process using the sieve, means such as manually shaking the sieve, striking it, or applying external vibrations using various devices are effective means. The method of applying ultrasonic waves on the sieve is also preferred. When the external force applied on the sieve is appropriate, the efficiency of the granulation process increases.

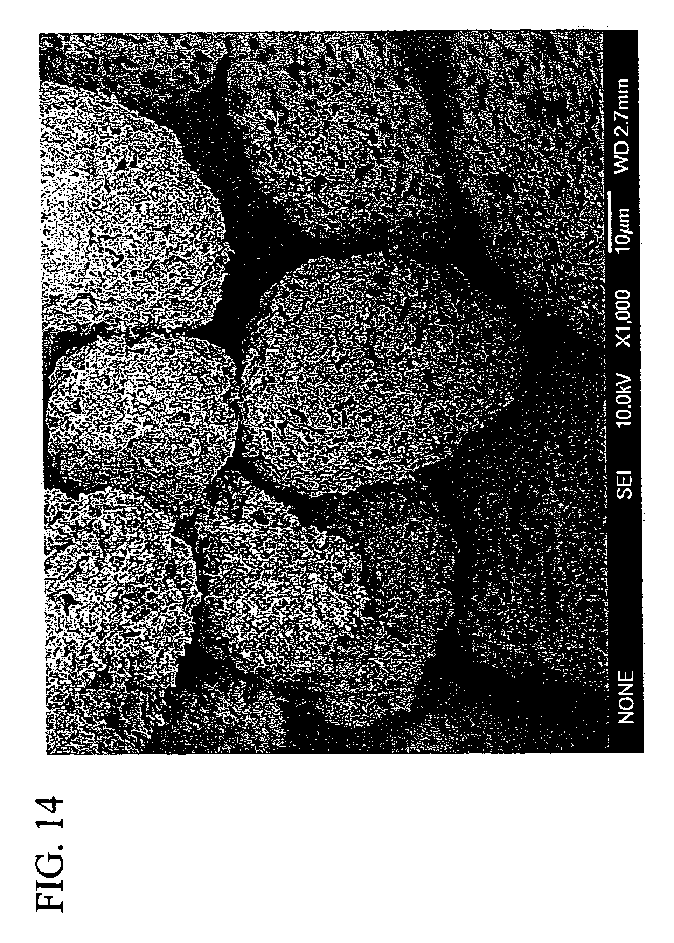

FIG. 14 shows the SEM image of α-SiAlON fluorescent material obtained in this manner. According to the present invention, it can be observed that the desired particle size, that is, "particle size greater than several tens of microns" can be obtained, and α-SiAlON powdered fluorescent material of "shape close to spherical shape" can be obtained. The Sample Shown in the image of FIG. 14, is the same as the one explained in Experiment 3 above, except for two points: the sintering time was 2 hours, and the powder after sintering was not classified.

### Example 1

The powdered fluorescent material of the present invention was prepared referring to the results of the experiments described above. This Example 1 is the powdered fluorescent material obtained after the chemical treatment of Sample FY10-63 prepared in Experiment 3 mentioned above.

An α-SiAlON yellow fluorescent material was selected as the powdered fluorescent material.

The calcium α-SiAION activated by this divalent europium, is generally expressed by the general formula: CaₚSi₁₂₋₍ₘ₊ₙ₎Alₘ₊ₙOₙN₁₆₋ₙ:Eu²⁺_{q}. For this Example 1, the following values were taken: p = 0.88, q=0.05, and m and n were determined according to p and q as follows: m=1.91, n=0.955. Accordingly, the composition was Ca_{0.88}Si_{9.135}Al_{2.865}O_{0.955}N_{15.045}:Eu²⁺_{0.05}.

Silicon nitride (Si₃N₄), aluminum nitride (AlN), calcium carbonate (CaCO₃), and europium oxide (Eu₂O₃) were used as the starting materials. According to the composition design mentioned above, 33.295 g of silicon nitride, 9.150 g of aluminum nitride, 6.865 g of calcium carbonate, and 0.685 g of europium oxide were weighed out on an electronic balance so that each batch weighed 50 g, and the composition was mixed for 2 hours in a wet planetary ball mill. The composition was dried in a rotary evaporator, and in the dried condition, it was broken down adequately using a mortar. The powder was granulated to an appropriate particle size using a sieve for experiments made of stainless steel mesh of nominal size 125 µm compliant with JIS Z 8801, and gently stored in a container with lid made of boron nitride. Next, the container with the powder was inserted in a sintering furnace, and it was sintered under a gas pressure of 5 atms in a nitrogen atmosphere at 1800°C. The sintering time was set to 24 hours. After sintering, when the powder was removed from the apparatus, the sintered substance that had hardened to lumps in the container was broken down to powder by applying a slight pressure in the mortar.

From this powder, particles with a particle size of 45 µm or less were removed using a sieve for experiments made of stainless steel mesh of nominal size 45 µm compliant with JIS Z 8801. The remaining powder with particle sizes of 45 µm or greater were sized into powder of particles with particle sizes of 63 µm or less using a stainless steel sieve of nominal mesh size 63 µm made for experiments, and this powder was taken as Sample FY 10-63.

Next, Sample FY10-63 was chemically treated, and the glass phase on the surface and at the interface was removed. More specifically, the dissolution process was performed using an acid solution prepared from hydrofluoric acid, sulfuric acid, and water. Five milliliters of hydrofluoric acid (HF), 5 ml of sulfuric acid (H₂SO₄), and 390 ml of pure water were mixed in a fluororesin beaker, and stirred for 5 minutes in a fluororesin magnetic-type stirrer. The hydrofluoric acid used as a guaranteed reagent made by Wako Pure Chemical Industries, Ltd. had a concentration of 46.0 to 48.0%, while the sulfuric acid was Wako Grade 1 made by Wako Pure Chemical Industries, Ltd. with a concentration of 95.0% or higher. Five grams of Sample FY10-63 was placed in this acid solution, and the mix was stirred for 30 minutes using a stirrer. After stirring, the solution was allowed to stand still for 30 seconds, the acid solution was removed using a dropping pipette taking care not to suck the settled down powdered fluorescent material, and when the solution was fully removed, pure water was again added and the powder was washed in this manner five times. Water was again added to the beaker, and ultrasonic waves were applied in the ultrasonic tank for 15 minutes. The transparent water became white and turbid. The solution was allowed to stand still for 30 seconds, the water was removed using a dropping pipette taking care not to suck the settled down powdered fluorescent material, and when the solution was fully removed, pure water was again added and the powder was washed in this manner five times. Finally, the powder was extracted using a filter paper, dried and taken as the sample after the chemical treatment of Sample FY 10-63.

The particle distribution of the powdered fluorescent material of Example 1, that is, the sample obtained after the chemical treatment of Sample FY10-63, was measured using the laser diffraction/ dispersion type particle distribution measuring apparatus (CILAS 1064 manufactured by Cilas). FIG. 13 shows the results of the measurement. The median particle size was 53.58 µm, the 10%-particle size was 38.60 µm, and the 90%-particle size was 74.58 µm. The cumulative frequency distribution shows that the percentage of particles with particle sizes of 32 µm or less was below 2% by mass.

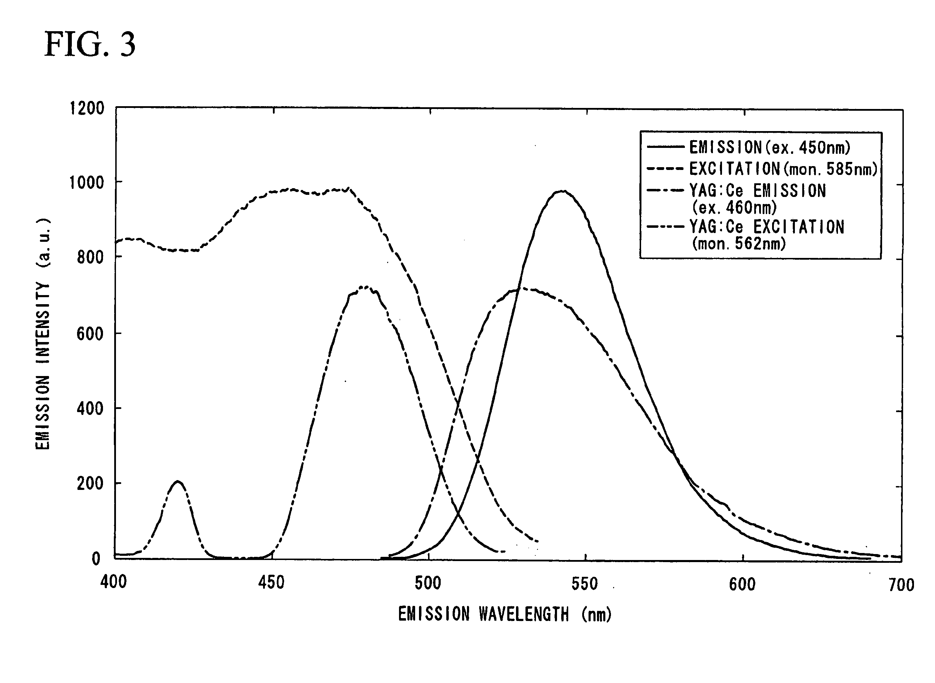

The excitation spectrum and emission spectrum of the powdered fluorescent material of Example 1 were measured using the fluorescence spectrophotometer (fluorescence spectrophotometer F-4500 manufactured by Hitachi, Ltd.). The spectra were corrected using Rhodamine B method and standard light source during the measurement with the fluorescence spectrophotometer. The emission spectrum was measured using an excitation wavelength of 450 nm. The excitation spectrum was measured using an emission-monitoring wavelength of 585 nm. The results are shown in FIG 3.

FIG. 3 shows both the excitation spectrum and emission spectrum of a commercially available YAG-based fluorescent material (general formula (Y, Gd)₃Al₃O₁₂: Ce) normally called YAG:Ce, for the sake of comparison. The emission spectrum of this YAG-based fluorescent material was measured at an excitation wavelength of 460 nm, while the excitation spectrum was measured at an emission-monitoring wavelength of 562 nm. The excitation peak wavelength was set to the excitation wavelength during measurement of emission spectrum, and the emission peak wavelength was set to the emission-monitoring wavelength during measurement of excitation spectrum.

From FIG. 3, the emission spectrum of the powdered fluorescent material of Example 1 has an intensity ratio of 135% at emission peak wavelength compared to the commercially available YAG:Ce, moreover, the total integrated energy value of the emission spectrum also is better. The excitation band is also wider and flatter compared to the commercially available YAG:Ce fluorescent material. The chromaticity coordinates on the CIE 1931 chromaticity chart indicating the luminescent chromaticity of powdered fluorescent material of Example 1 were (0.52, 0.48).

### Example 2

A white LED lamp provided with the powdered fluorescent material made in Example 1 was manufactured.

FIG. 1 shows the cross-sectional view of the white LED lamp manufactured in Example 2. The white LED lamp with an upper part having a spherical surface and the function of a lens, has an approximately circular cylindrical shape, or a shape similar to that of a dome, comprises lead wires 2 and 3, a blue LED element 4, a bonding wire 5 made of a thin metallic wire, a fluorescent material-dispersed resin layer 6 having a powdered fluorescent material 7 made in Example 1 dispersed in a transparent resin, and a transparent molding resin 8. The blue LED element 4 is connected electrically to one lead wire 2 by a conductive paste not shown in the figure, and also connected electrically to the other lead wire 3 by the bonding wire 5. The powdered fluorescent material 7 made in Example 1 is dispersed in the transparent resin, and this fluorescent material-dispersed resin layer 6 covers the blue LED element 4. The powdered fluorescent material 7 is excited by the blue light emitted by the blue LED element 4 and it emits yellow light. The blue light emitted by the blue LED element 4 and the yellow light emitted by the powdered fluorescent material 7 have a complementary relationship. The quantity of powdered fluorescent material 7 applied is adjusted such that the chromaticity coordinate of the mixed light coincides with the black body radiation locus. In practice, the quantity of the fluorescent material-dispersed resin layer 6 dispersed with the powdered fluorescent material 7 is adjusted. In this manner, the LED lamp 1 is the white LED lamp in which the chromaticity coincides with the black body radiation locus.

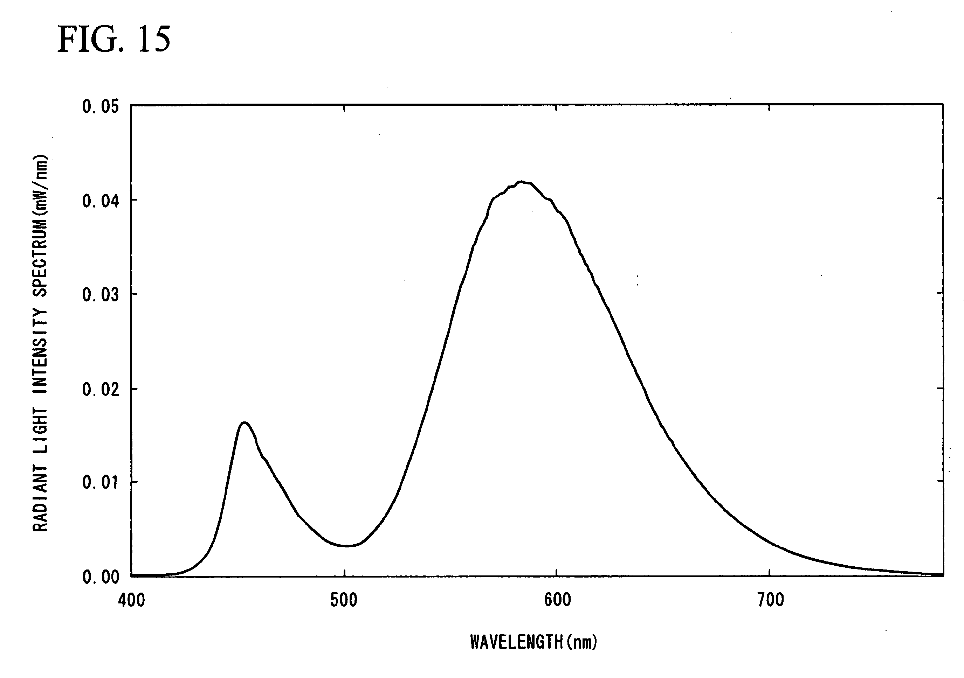

FIG. 15 shows the emission spectrum of the white LED lamp 1 of Example 2. A high speed LED test measurement equipment OL-770-LED made by Optronic Laboratories, Inc. was used for measuring the optical characteristics. The emitted light chromaticity coordinate (x, y) on the CIE 1931 chromaticity chart is (0.459, 0.415), and the correlated color temperature is 2750 K. This is classified into five kinds of white color in JIS Z 9112-1990, "Classification of fluorescent lamps by chromaticity and color rendering property" namely, daylight white, neutral white, white, warm white, incandescent lamp color. The luminous efficacy of 30.42 lm/W (lumen/Watt) was extremely high. The luminous efficacy of commercially available white LED lamp with the color of incandescent lamp is in the range of 20 to 23 Im/W.

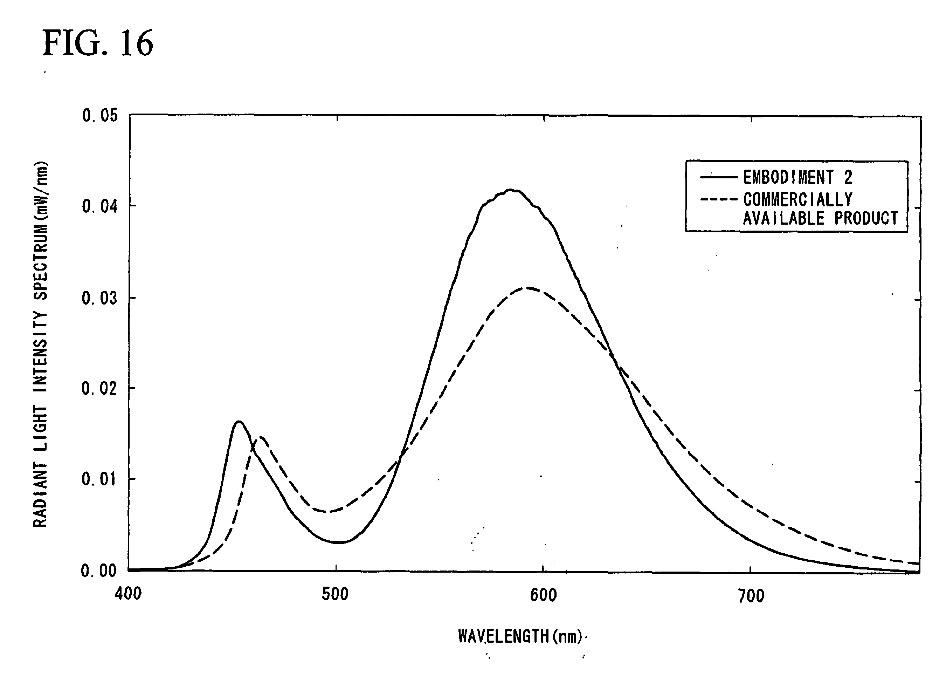

FIG. 16 shows the results of comparison of emission spectra of the white LED lamp of Example 2 and the commercially available white LED lamp with the color of incandescent lamp. The luminous efficacy of the commercially available white LED lamp with the color of incandescent lamp, which is compared here, is 22.5 lm/W. It can be observed that the light-emitting intensity of the white LED lamp of this Example 2 is excellent. The luminous efficacy of white LED lamp is determined by three factors, namely, efficiency of the blue LED element, efficiency of the fluorescent material, and the placement construction. However, the luminous efficacy of white LED lamp of Example 2 is 30% to 50% higher than that of commercially available lamps. It is difficult to attribute this result to the difference in efficiencies of the blue LED elements. Accordingly, the increase in efficiency of powdered fluorescent material due to the technique of the present invention and improvements to the placement construction are considered to have contributed largely to the enhanced luminous efficacy of the white LED lamp.

### Example 3

FIG. 2 shows the cross-sectional view of the chip type white LED lamp of Example 3 according to the present invention.

A chip type white LED lamp 51 comprises electrode patterns 59 and 60 provided on a support substrate 61, lead wires 52 and 53 connected to said electrode patterns, a blue LED element 54 mounted on the electrode pattern 59, a bonding wire 55 that electrically connects the upper electrode on the blue LED element 54 and the electrode pattern 60, a fluorescent material-dispersed resin layer 56 applied and cured to cover the blue LED element 54 formed by epoxy resin in which the powdered fluorescent material 57 made in Example 1 is dispersed, a wall surface member 62 with a bowl-shaped hole joined on a support substrate 61, and a transparent sealing resin 58 for sealing said bowl-shaped hole.

A square alumina ceramic plate was used as the support substrate 61. The electrode patterns 59 and 60 of with thickness in the order of a few microns made of copper were formed on by sputtering the support substrate 61. Practically no level difference exists between the electrode patterns 59, 60, and the support substrate 61. Parts of each of the electrode patterns 59 and 60 were connected to each of the lead wires 52 and 53 by a high melting point solder. The end of the electrode pattern 59 was extended to the center of the support substrate 61, and the blue LED element 54 was mounted and fixed at this central part. The lower electrode of the white LED element 54 was electrically connected to one of the electrode patterns 59 with conductive paste not shown in the figure. The upper electrode was also electrically connected to the other electrode pattern 60 by the bonding wire 55 made of a thin metallic wire.

The support substrate 61 comprises a wall surface member 62 with a bowl-shaped recess made of a material with high reflectivity of visible light rays, such as alumina ceramics, and arranged in such a manner as to accommodate the blue LED element 54 and the fluorescent material-dispersed resin layer 56 in said recess. The transparent sealing resin 58 is filled and cured in the hole of the wall surface member 62 for sealing the blue LED element 54 and the fluorescent material-dispersed resin layer 56 in the hole. The powdered fluorescent material 57 made in Example 1 was dispersed in a transparent resin 56A, and this fluorescent material-dispersed resin layer 56 covered the blue LED element 54. The powdered fluorescent material 57 is excited by the blue light emitted by the blue LED element 54 and it emits yellow light. The blue light emitted by the blue LED element 54 and the yellow light emitted by the powdered fluorescent material 57 have a complementary relationship. The quantity of powdered fluorescent material 57 applied is adjusted such that the chromaticity coordinate of the mixed color coincides with the black body radiation locus. In practice, the quantity of the fluorescent material-dispersed resin layer 56 dispersed with the powdered fluorescent material 57 is adjusted. In this manner, this LED lamp is a white LED lamp in which the chromaticity coincides with the black body radiation locus.

The optical characteristics of the white LED lamp of the Example 3 are similar to those of the lamp in Example 2. The chip-type white LED lamp of this example has an advantage in that it can be mounted on the surface, as opposed to bullet-shaped white LED lamp which needs a hole to be made in the substrate.

## Claims

1. A powdered fluorescent material that is excited by visible light and emits visible light, comprising: particles with particle sizes of 20 µm or less at a content of below 2% by mass.

2. The powdered fluorescent material according to claim 1, wherein a median particle size is not less than 30 µm and not more than 80 µm.

3. The powdered fluorescent material according to claim 1, wherein a particle size at which cumulative weight of the particles becomes 90% is 100 µm or less.

4. The powdered fluorescent material according to claim 1, wherein a particle size at which cumulative weight of the particles becomes 10% is 30 µm or more and a median particle size is not less than 40 µm and not more than 70 µm.

5. The powdered fluorescent material according to claim 1 emitting visible light in a range between bluish green light and red light when excited by blue light.

6. The powdered fluorescent material according to claim 1 being an oxynitride fluorescent material or a nitride fluorescent material.

7. The powdered fluorescent material according to claim 1 being a europium-activated SiAlON.

8. The powdered fluorescent material according to claim 1 being a calcium α-SiAlON.

9. A method for manufacturing a powdered fluorescent material according to claim 1, comprising the steps of:
sintering a raw material powder of the fluorescent material;
dispersing the powder in a liquid after said sintering, and stirring or subjecting to vibration; and
removing said liquid wherein the fine powder is dispersed after said stirring or after being subjected to said vibration while said powder is being suspended and has not settled down to obtain only settled down coarse particles.

10. The method for manufacturing a powdered fluorescent material according to claim 9, wherein the liquid containing the fine particles suspended therein is removed within 2 minutes after the liquid is stirred or after the liquid has been subjected to the vibrations.

11. An optical device comprising:
a semiconductor light-emitting element that emits visible light; and
the powdered fluorescent material according to claim 1 disposed so as to emit light when excited by visible light emitted from said semiconductor light-emitting element.

12. The light-emitting device according to claim 11, wherein said semiconductor light-emitting element is a blue light-emitting diode element and said powdered fluorescent material is a calcium europium-activated α-SiAlON.

13. The light-emitting device according to claim 11 further comprising a fluorescent material-dispersed resin layer, said powdered fluorescent material being dispersed in a transparent resin, said resin layer surrounding said semiconductor light-emitting element.

14. An illumination apparatus comprising a light-emitting device according to claim 11 as a light source.

15. The method for manufacturing a powdered fluorescent material according to claim 9, further comprising a granulation step wherein a raw material powder is wet mixed, placed in a sieve, and subjected to vibration or shock to obtain an aggregate of said raw material powder, wherein a raw material powder of the fluorescent material after said granulation is subjected to said step of sintering.

16. The method for manufacturing a powdered fluorescent material according to claim 15, wherein said sieve has a nominal mesh size of 40 µm to 200 µm.

17. The method for manufacturing a powdered fluorescent material according to claim 9, wherein said liquid is an acid solution in which said powder is chemically processed.

18. The method for manufacturing a powdered fluorescent material according to claim 17, wherein said acid solution is acid mixture solution including hydrofluoric acid, sulfuric acid, and water.

19. The method for manufacturing a powdered fluorescent material according to claim 17, wherein said powdered fluorescent material is a nitride fluorescent material or an oxynitride fluorescent material activated by rare earth elements.

20. The method for manufacturing a powdered fluorescent material according to claim 19, wherein at least one of said rare earth elements is europium.

21. The method for manufacturing a powdered fluorescent material according to claim 20, wherein said fluorescent material is a calcium α-SiAlON.

## Patentansprüche

1. Pulvriges, fluoreszierendes Material, das durch sichtbares Licht angeregt wird und sichtbares Licht emittiert, umfassend: Partikel mit Partikelgrößen von 20 µm oder weniger bei einem Gehalt von unter 2 Massen-%.

2. Pulvriges, fluoreszierendes Material nach Anspruch 1, worin die mittlere Partikelgröße nicht weniger als 30 µm und nicht mehr als 80 µm ausmacht.

3. Pulvriges, fluoreszierendes Material nach Anspruch 1, worin die Partikelgröße, bei der das kumulative Gewicht der Partikel 90 % annimmt, 100 µm oder weniger beträgt.

4. Pulvriges, fluoreszierendes Material nach Anspruch 1, worin die Partikelgröße, bei der das kumulative Gewicht der Partikel 10 % annimmt, 30 µm oder mehr beträgt und die mittlere Partikelgröße nicht weniger als 40 µm und nicht mehr als 70 µm ausmacht.

5. Pulvriges, fluoreszierendes Material nach Anspruch 1, das, wenn es mit blauem Licht angeregt wird, sichtbares Licht in einem Bereich zwischen bläulich-grünem Licht und rotem Licht emittiert.

6. Pulvriges, fluoreszierendes Material nach Anspruch 1, wobei es sich um ein fluoreszierendes Oxynitridmaterial oder ein fluoreszierendes Nitridmaterial handelt.

7. Pulvriges, fluoreszierendes Material nach Anspruch 1, wobei es sich um ein Europium-aktiviertes SiAlON handelt.

8. Pulvriges, fluoreszierendes Material nach Anspruch 1, wobei es sich um ein Calcium-α-SiAION handelt.

9. Verfahren zur Herstellung eines pulvrigen, fluoreszierenden Materials nach Anspruch 1, umfassend die folgenden Schritte:
das Sintern eines Rohmaterialpulvers des fluoreszierenden Materials;
das Dispergieren des Pulvers in einer Flüssigkeit nach dem Sintern sowie das Rühren oder Aussetzen des Pulvers gegenüber Vibration;
das Entfernen der Flüssigkeit, worin das feine Pulver dispergiert ist, nachdem es gerührt oder Vibration ausgesetzt wurde, während das Pulver suspendiert ist und sich noch nicht abgesetzt hat, um nur abgesetzte Grobpartikel zu erhalten.

10. Verfahren zur Herstellung eines pulvrigen, fluoreszierenden Materials nach Anspruch 9, worin die Flüssigkeit, die darin suspendiert die feinen Partikel enthält, innerhalb von 2 min, nachdem die Flüssigkeit gerührt wurde oder nachdem die Flüssigkeit den Vibrationen ausgesetzt wurde, entfernt wird.

11. Optische Vorrichtung, umfassend:
ein Licht emittierendes Halbleiterelement, das sichtbares Licht emittiert; und
das pulvrige, fluoreszierende Material nach Anspruch 1, das so ausgebildet ist, dass es Licht emittiert, wenn es mit sichtbarem Licht, das von dem Licht emittierenden Halbleiterelement emittiert wird, angeregt wird.

12. Licht emittierende Vorrichtung nach Anspruch 11, worin das Licht emittierende Halbleiterelement ein blaues Licht emittierendes Diodenelement und das pulvrige, fluoreszierende Material ein Calcium-Europium-aktiviertes α-SiAION ist.

13. Licht emittierende Vorrichtung nach Anspruch 11, weiters umfassend eine Harzschicht mit dispergiertem, fluoreszierendem Material, wobei das pulvrige, fluoreszierende Material in einem durchsichtigen Harz dispergiert ist, wobei die Harzschicht das Licht emittierende Halbleiterelement umgibt.

14. Leuchtvorrichtung, umfassend eine Licht emittierende Vorrichtung nach Anspruch 11 als Lichtquelle.

15. Verfahren zur Herstellung eines pulvrigen, fluoreszierenden Materials nach Anspruch 9, weiters umfassend einen Granulierungsschritt, worin ein Rohmaterialpulver feucht gemischt wird, in ein Sieb gelegt wird und Vibration oder Erschütterung ausgesetzt wird, um ein Aggregat des Rohmaterialpulvers zu erhalten, worin ein Rohmaterialpulver des fluoreszierenden Materials nach der Granulierung dem Schritt des Sinterns unterzogen wird.

16. Verfahren zur Herstellung eines pulvrigen, fluoreszierenden Materials nach Anspruch 15, worin das Sieb eine nominale Maschenweite von 40 µm bis 200 µm aufweist.

17. Verfahren zur Herstellung eines pulvrigen, fluoreszierenden Materials nach Anspruch 9, worin es sich bei der Flüssigkeit um eine Säurelösung handelt, in der das Pulver chemisch prozessiert wird.

18. Verfahren zur Herstellung eines pulvrigen, fluoreszierenden Materials nach Anspruch 17, worin es sich bei der Säurelösung um Säuregemischlösung handelt, die Fluorwasserstoffsäure, Schwefelsäure und Wasser umfasst.

19. Verfahren zur Herstellung eines pulvrigen, fluoreszierenden Materials nach Anspruch 17, worin das pulvrige, fluoreszierende Material ein fluoreszierendes Nitridmaterial oder ein fluoreszierendes Oxynitridmaterial ist, das durch Seltenerdelemente aktiviert ist.

20. Verfahren zur Herstellung eines pulvrigen, fluoreszierenden Materials nach Anspruch 19, worin zumindest eines der Seltenerdelemente Europium ist.

21. Verfahren zur Herstellung eines pulvrigen, fluoreszierenden Materials nach Anspruch 20, worin das fluoreszierende Material ein Calcium-α-SiAION ist.

## Revendications

1. Matériau fluorescent en poudre, qui est excité par la lumière visible et émet de la lumière visible, comprenant: des particules d'une taille de particule de 20µm ou moins à une teneur inférieure à 2% en masse.

2. Matériau fluorescent en poudre selon la revendication 1, dans lequel une taille de particule moyenne n'est pas inférieure à 30µm et n'est pas supérieure à 80µm.

3. Matériau fluorescent en poudre selon la revendication 1, dans lequel une taille de particule à laquelle le poids cumulatif des particules atteint 90% est de 100µm ou moins.

4. Matériau fluorescent en poudre selon la revendication 1, dans lequel une taille de particule à laquelle le poids cumulatif des particules atteint 10% est de 30µm ou plus, et une taille de particule moyenne n'est pas inférieure à 40µm et n'est pas supérieure à 70µm.

5. Matériau fluorescent en poudre selon la revendication 1, émettant de la lumière visible dans une plage entre la lumière bleu verte et la lumière rouge lorsqu'elle est excitée par la lumière bleu.

6. Matériau fluorescent en poudre selon la revendication 1, qui est un matériau fluorescent d'oxynitrure ou un matériau fluorescent de nitrure.

7. Matériau fluorescent en poudre selon la revendication 1, qui est un SiAION europium-activé.

8. Matériau fluorescent en poudre selon la revendication 1, qui est un α-SiAION de calcium.

9. Procédé de fabrication d'un matériau fluorescent en poudre selon la revendication 1, comprenant les étapes de:
fritter une poudre de matériau brut du matériau fluorescent;
disperser la poudre dans un liquide après ledit frittage, et agiter ou soumettre à des vibrations; et
retirer ledit liquide lorsque la poudre fine est dispersée après ladite agitation ou après avoir été soumis auxdites vibrations pendant que ladite poudre est suspendue et ne s'est pas déposée pour obtenir seulement des particules grossières qui se sont déposées.

10. Procédé de fabrication d'un matériau fluorescent en poudre selon la revendication 9, dans lequel le liquide contenant les particules fines suspendues dans celui-ci est retiré dans les 2 minutes après l'agitation du liquide ou après que celui-ci a été soumis aux vibrations.

11. Dispositif optique comprenant:
un élément émetteur de lumière semi-conducteur qui émet de la lumière visible; et
le matériau fluorescent en poudre selon la revendication 1 disposé de façon à émettre de la lumière lorsqu'il est excité par la lumière visible émise par ledit élément émetteur de lumière semi-conducteur.

12. Dispositif d'émission de lumière selon la revendication 11, dans lequel ledit élément émetteur de lumière semi-conducteur est un élément de diode d'émission de lumière bleue, et ledit matériau fluorescent en poudre est un α-SiAION de calcium europium activé.

13. Dispositif émetteur de lumière selon la revendication 11, comprenant en outre une couche de résine fluorescente dispersée dans le matériau, ledit matériau fluorescent en poudre étant dispersé dans une résine transparente, ladite couche de résine entourant ledit élément émetteur de lumière semi-conducteur.

14. Appareil d'éclairage comprenant un dispositif émetteur de lumière selon la revendication 11 comme source de lumière.

15. Procédé de fabrication d'un matériau fluorescent en poudre selon la revendication 9, comprenant en outre une étape de granulation, où une poudre de matériau brut est mélangée à l'état humide, placée dans un tamis et soumise à des vibrations ou des chocs pour obtenir un agrégat de ladite poudre de matériau brut, où une poudre de matériau brut du matériau fluorescent après ladite granulation est soumise à ladite étape de frittage.

16. Procédé de fabrication d'un matériau fluorescent en poudre selon la revendication 15, où ledit tamis a une taille de maille nominale de 40µm à 200µm.

17. Procédé de fabrication d'un matériau fluorescent en poudre selon la revendication 9, dans lequel ledit liquide est une solution d'acide dans laquelle ladite poudre est traitée chimiquement.

18. Procédé de fabrication d'un matériau fluorescent en poudre selon la revendication 17, dans lequel ladite solution d'acide est une solution de mélange d'acides comportant l'acide fluorhydrique, l'acide sulfurique et de l'eau.

19. Procédé de fabrication d'un matériau fluorescent en poudre selon la revendication 17, dans lequel ledit matériau fluorescent en poudre est un matériau fluorescent de nitrure ou un matériau fluorescent d'oxynitrure activé par des éléments de terres rares.

20. Procédé de fabrication d'un matériau fluorescent en poudre selon la revendication 19, dans lequel au moins un desdits éléments de terres rares est l'europium.

21. Procédé de fabrication d'un matériau fluorescent en poudre selon la revendication 20, dans lequel ledit matériau fluorescent est un α-SiAION de calcium.
